# EUROPEAN PATENT APPLICATION

(11) **EP 4 557 930 A1**
(43) Date of publication of application: **21.05.2025**
(21) Application number: 23839891.1
(22) Date of filing: 10.07.2023
(51) Int. Cl.: H10K 85/40, H10K 85/60, H10K 85/10, H10K 50/15, H10K 50/16

(54) **CHARGE TRANSPORT COMPOSITE AND HIGH-RESOLUTION PATTERNING METHOD FOR CHARGE TRANSPORT LAYER COMPRISING SAME, CHARGE TRANSPORT LAYER COMPOSITION COMPRISING SAME, AND ORGANIC LIGHT-EMITTING DEVICE COMPRISING SAME**

(30) Priority: 11.07.2022 KR 20220085062
(71) Applicant: IUCF-HYU (Industry-University Cooperation Foundation Hanyang University), Seoul 04763 (KR)
(72) Inventor: KIM, Do Hwan, Seoul 05229 (KR); KWEON, Hyukmin, Seoul 06346 (KR); JEONG, Uk Jin, Seoul 02253 (KR); HA, Bo Ri Na, Seoul 05014 (KR); CHOI, Seok Ran, Seoul 02553 (KR); CHO, Jeong Ho, Seoul 06191 (KR); KIM, Seonkwon, Seoul 05507 (KR); KANG, Moon Sung, Seoul 04154 (KR); LEE, Seung Han, Seoul 05790 (KR)
(74) Representative: dompatent von Kreisler Selting Werner - Partnerschaft von Patent- und Rechtsanwälten mbB
(86) International application number: PCT/KR2023/009730
(87) International publication number: WO 2024/014798

(57) **Abstract**

Disclosed are a charge-transporting complex and a method for high-resolution patterning of a charge-transporting layer including the charge-transporting complex, a charge-transporting layer composition including the charge-transporting complex, and an organic light-emitting device including the charge-transporting complex. More particularly, the present invention provides a charge-transporting complex, including: a curable organic semiconductor; and an organic silica precursor, wherein the organic silica precursor and the curable organic semiconductor form a silicone (-Si-O-Si-) network structure together, wherein the curable organic semiconductor includes a cross-linking functional group.

## Description

### [Technical Field]

The present invention relates to a charge-transporting complex, a method for high-resolution patterning of a charge-transporting layer including the charge-transporting complex, a charge-transporting layer composition including the charge-transporting complex and an organic light-emitting device including the charge-transporting complex, and more particularly a silicone (-Si-O-Si-)-containing charge-transporting complex having a high-durability silicone (-Si-O-Si-) network, a method for high-resolution patterning of a charge-transporting layer including the charge-transporting complex, a charge-transporting layer composition including the charge-transporting complex and an organic light-emitting device including the charge-transporting complex.

### [Background Art]

As realistic content and Real Metaverse (five senses augmentation technology) based on the construction of hyper-connected interactions between users and objects are rapidly emerging as next-generation IT content driving industries, visual-based hyper-realistic and immersive VR/AR/MR/XR devices that play a pivotal role in human senses and cognitive functions are attracting great attention.

Microdisplays, which are core elements responsible for the visual elements of hyper-realistic VR/AR/MR/XR technologies, serve as a medium to convey information to users by stimulating the most sensitive sense of vision among human senses, so their technical performance requirements are very high. Therefore, to provide users with an overwhelming sense of immersion and prevent adverse reactions (dizziness, vomiting) in the human body, a microdisplay that can implement i) an ultra-high-resolution RGB pattern of 3,000 PPI or more, ii) a fast response speed, iii) color purity similar to reality, and iv) low power consumption is required.

Organic light-emitting diodes (OLEDs) are gaining attention as next-generation displays that can effectively meet the performance requirements of ultra-realistic VR/AR/MR/XR microdisplays due to advantages such as i) excellent color reproducibility, ii) fast frame rates, iii) wide viewing angles, and iv) low power consumption. However, due to the inherent low durability of a hole-transporting layer, the implementation of ultra-high-resolution RGB patterns is extremely limited, so the demand for ultra-precision micropatterning technology of hole-transporting layers to solve this problem is rapidly increasing.

Various pattern technologies such as printing techniques, fine metal mask (FMM) patterns, orthogonal photolithography, and self-assembly patterns are being developed to implement ultra-high resolution patterns of hole-transporting layers. However, there are still limitations in resolution, and there are various problems such as non-uniformity of patterns, degradation of luminescence performance depending on processes, and restrictions on multi-pattern processes based on solution processes. On the other hand, photolithography and dry etching are the most industrially optimized high-resolution pattern process technologies that can easily implement precise ultra-fine patterns with high efficiency. However, they require durability of materials that can withstand physical and chemical damage that is inevitably caused during the processes, so they have limitations that make it difficult to apply them to hole-transporting layers.

For example, Korean Patent No. 1350658 discloses a technology for developing an OLED device in which a charge-transporting layer is patterned in subpixel units through a photolithography process by adding a cross-linking agent (aziridine, carbodiimide, oxirane, allyl compound, and silane coupling agent) to a material constituting a charge-transporting layer to secure chemical resistance to a wet process. However, since the pattern is patterned using a wet process rather than a dry process, an undercut phenomenon occurs due to isotropic etching, which has limitations in that the pattern density and uniformity are low.

Tsai, Kuen-Wei, et al. have disclosed a technology for manufacturing OLED devices through a continuous solution process using a curable hole transport layer material (Oxe-DCDPA) introduced with oxetane, introducing a multilayer hole transport layer by using a hole transport layer with secured chemical resistance, and also implementing a small-molecule organic light emitting layer through a solution process, thereby fabricating a solution process-based multilayer OLED device to lower the operating voltage and simultaneously realizing excellent external quantum efficiency (26.1%) and luminous efficiency (94.8 cd/A). However, since a high-resolution pattern of the hole total layer is impossible, pixel crosstalk may occur when applied to a high-resolution OLED device.

Lim, Younhee, et al. have disclosed a technology for manufacturing OLED devices through a continuous solution process using a curable hole-transport layer material (TEVS-TPD) with a silicone cross-linking functional group, which secures the chemical resistance of the hole-transport layer through the design of the material and improves the charge mobility characteristics of a hole-transporting layer by increasing the conjugation length through the connection between organic semiconductor molecules, thereby securing OLED performance such as external quantum efficiency (6.4%) and power efficiency (13.5 lm/W). However, no research attempt has been made to implement an ultra-high-resolution pattern of the hole-transport layer, and pixel crosstalk may be induced when an unpatterned material is applied to a high-resolution OLED device.

That is, in the case of related research on curable charge-transporting layers based on small-molecule organic semiconductors, the development of OLED devices for solution processes by securing the chemical resistance of a charge-transporting layer have been mainly focused, so no research attempts have been made on implementing ultra-high-resolution patterns of OLED common layers. In addition, a technology for a charge-transporting layer pattern based on a photolithography process has been reported, but the pattern is implemented through a wet etching method, which has limitations such as limited pattern resolution and low pattern uniformity, and research on a technology for implementing an ultra-fine pattern of several micrometers using a charge-transporting layer material that is resistant also to a dry etching method has not been reported.

Therefore, there is a need for research into a charge-transporting layer that can improve etch resistance and chemical resistance while enhancing luminescence characteristics such that patterning can be performed through a photolithography process and a dry etching method.

### [Disclosure]

### [Technical Problem]

Therefore, the present invention has been made in view of the above problems, and it is one object of the present invention to provide a charge-transporting complex with a silicone (-Si-O-Si-) network which is based on a commercially available charge-transporting layer material and which can be directly applied to photolithography and a dry etching method, which are established ultra-high-resolution pattern technologies, due to secured high durability (chemical resistance and etching resistance); a method for high-resolution patterning of a charge-transporting layer including the charge-transporting complex, a charge-transporting layer composition including the charge-transporting complex, and an organic light-emitting device including the charge-transporting complex.

It is another object of the present invention to provide a charge-transporting complex capable of simultaneously increasing chemical resistance and etching resistance without deteriorating the optoelectronic properties by implementing a silicone (-Si-O-Si-) network by a simultaneous curing reaction or cross-curing reaction between small-molecule organic semiconductor and organic silica precursor to be introduced, a method for high-resolution patterning of a charge-transporting layer including the charge-transporting complex, a charge-transporting layer composition including the charge-transporting complex, and an organic light-emitting device including the charge-transporting complex.

It is yet another object of the present invention to provide a charge-transporting complex that can secure chemical resistance/etch resistance and improve luminous efficiency by introducing an organic silica precursor, capable of forming a silicone (-Si-O-Si-) network through a cross-linking reaction with an organic semiconductor, to a curable small-molecule organic semiconductor, a method for high-resolution patterning of a charge-transporting layer including the charge-transporting complex, a charge-transporting layer composition including the charge-transporting complex, and an organic light-emitting device including the charge-transporting complex.

### [Technical Solution]

In accordance with an aspect of the present invention, the above and other objects can be accomplished by the provision of a charge-transporting complex, including: a curable organic semiconductor; and an organic silica precursor, wherein the organic silica precursor and the curable organic semiconductor form a silicone (-Si-O-Si-) network structure together, wherein the curable organic semiconductor includes a cross-linking functional group.

The cross-linking functional group may include at least one of a vinyl group, a vinyl derivative, an oxetane group, a boronic acid group, trifluoro vinyl ether, benzocyclobutene and epoxide.

The cross-linking functional group may include a functional group represented by one of Formulas 3 to 8 below:

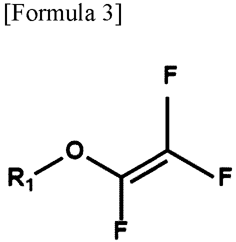

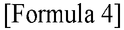

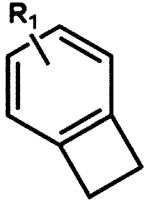

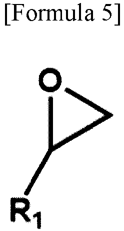

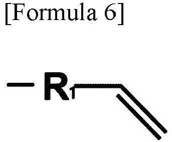

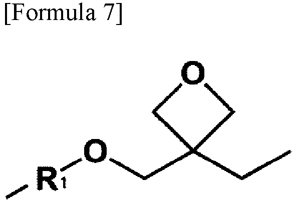

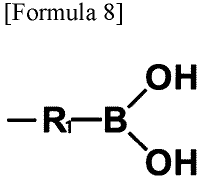

in Formulas 3 to 8, R₁ each independently includes one of a hydrogen, a heavy hydrogen, a cyano group, a halogen group, an amino group, a thiol group, a hydroxy group, a nitro group, a carbonyl group, an ether group, a silane group, a siloxane group, a substituted or unsubstituted alkyl group having 1 to 20 carbon atoms, a substituted or unsubstituted cycloalkyl group having 3 to 20 carbon atoms, a substituted or unsubstituted alkenyl group having 2 to 20 carbon atoms, a substituted or unsubstituted alkynyl group having 2 to 20 carbon atoms, a halogenated alkyl group having 1 to 20 carbon atoms, a substituted or unsubstituted fluorenyl group, a substituted or unsubstituted aryl group having 6 to 30 carbon atoms, a substituted or unsubstituted aryloxy group having 6 to 30 carbon atoms, a substituted or unsubstituted alkoxy group having 1 to 20 carbon atoms, a substituted or unsubstituted alkylsilyl group having 1 to 20 carbon atoms, a substituted or unsubstituted arylsilyl group having 6 to 30 carbon atoms, a substituted or unsubstituted arylalkyl group having 7 to 30 carbon atoms, a substituted or unsubstituted alkenyloxyl group having 2 to 30 carbon atoms, a substituted or unsubstituted aryl group having 8 to 30 carbon atoms alkenylaryl group, a substituted or unsubstituted arylalkoxy group having 7 to 30 carbon atoms, a substituted or unsubstituted arylalkenyl group having 8 to 30 carbon atoms and a substituted or unsubstituted alkoxycarbonyl group having 2 to 20 carbon atoms.

The curable organic semiconductor may be a hole-transporting compound to which the cross-linking functional group is bonded, wherein the hole-transporting compound includes at least one of a triphenyl amine derivative, an aromatic diamine derivative, an arylene diamine-based derivative, a carbazole derivative, a spiro-arylene diamine derivative, a starburst-type amine-based derivative, a triarylamine derivative, a thiophene derivative, and a triarylphosphine derivative.

The curable organic semiconductor may include at least one of N4,N4'-bis(4-(6-((3-ethyloxetan-3-yl)methoxy)hexyloxy)phenyl)-N4,N4'-bis(4-methoxyphenyl)biphenyl-4,4'-diamine (QUPD), N4,N4'-bis(4-(6-((3-ethyloxetan-3-yl)methoxy)hexyl)phenyl)-N4,N4'-diphenylbiphenyl-4,4'-diamine (OTPD), oxe-DCDPA(N,N-bis(4-(6-((3-ethyloxetane-3-yl)methoxy)hexyloxy)phenyl)-3,5-di(9H-carbazol-9-yl)benzenamine), vinylbenzyl (VB)-TCTA (tris(4-carbazoyl-9-ylphenyl)amine), N,N'-bis(tolyl)-N,N'-bis(vinylphenyl)-1,1'-biphenyl-4,4'-diamine (DV-TPD), tris[(p-trifluorovinyloxy-biphenyl)]amine (TPA-TFVE), MUPD and AUPD.

The curable organic semiconductor may be an electron-transporting compound having the cross-linking functional group bonded thereto, and the electron-transporting compound may include at least one of an oxadiazole derivative, a triazole derivative, a phenanthroline derivative, a benzoxazole derivative, a benzothiazole derivative, a benzimidazole derivative, a triazine derivative, a benzoquinone derivative, a pyridine derivative, an anthraquinone derivative, a polyquinoline derivative, and a polyfluorene derivative.

The curable organic semiconductor may include at least one of DV-46PymTAZ(4,6-bis[4-(5-{4-[(4-vinylbenzyloxy)methylphenyl}-4-(4-tert-butyl-phenyl)-4H-1,2,4-triazol-3-yl)phenyl]-2-methylpyrimidie), SMH-E-10, TV-TmPY(1,3,5-tris(5(4-vinylphenyl)pyridin-3-yl)benzene) and U-BmPyPB.

Luminescence intensity and durability of the charge-transporting complex may be adjusted depending upon a concentration of the organic silica precursor.

The concentration of the organic silica precursor may be 1.40 % by weight to 7.13 % by weight based on the charge-transporting complex.

The organic silica precursor may include a compound represented by one of Formulas 9 to 19 below: 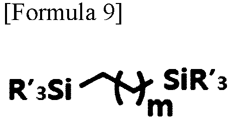 in Formula 9, R' includes one to three halogen elements or one to three alkoxy (-O-(CH₂)ₓ-CH₃, where X is an integer of 0 to 8.), and m is an integer of 0 to 20,

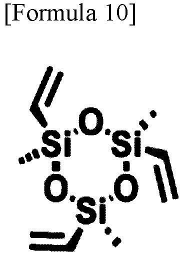

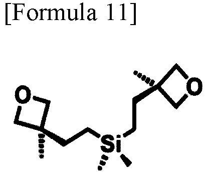

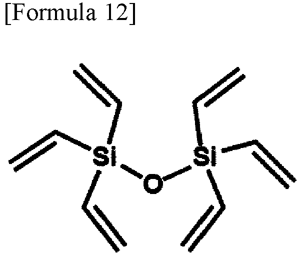

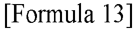

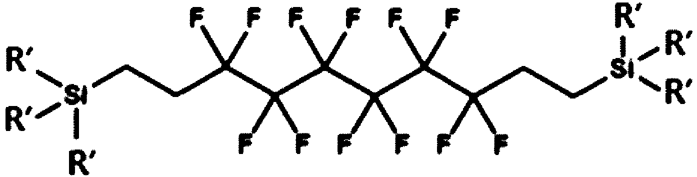

in Formula 13, R' includes one to three halogen elements or one to three alkoxy (-O-(CH₂)ₓ-CH₃, where X is an integer from 0 to 8,

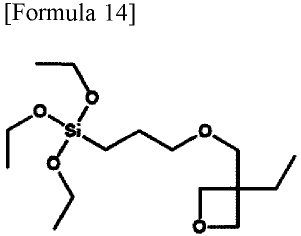

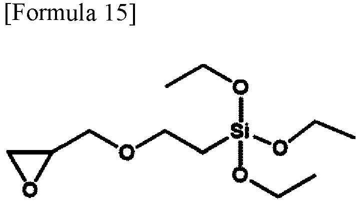

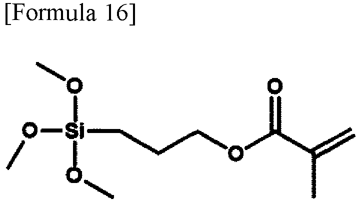

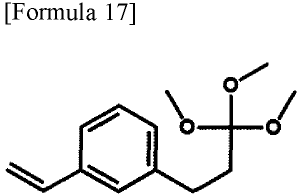

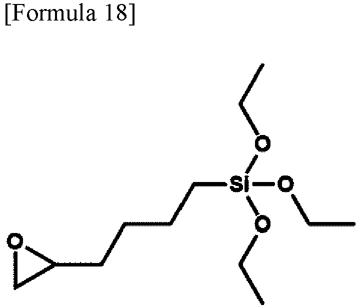

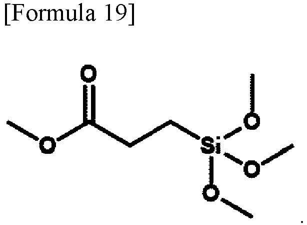

The silicone (-Si-O-Si-) network structure may be one of a silicone (-Si-O-Si-)-integrated Single Phase Network (SPN) and a silicone (-Si-O-Si-)-integrated Interpenetrating Polymer Network (IPN).

In accordance with another aspect of the present invention, provided is a patterning method for a charge-transporting layer, the patterning method including: forming a charge-transporting layer including the charge-transporting complex according to the present invention on a substrate; forming a photoresist on the charge-transporting layer; patterning the photoresist to form a photoresist pattern; forming a charge-transporting layer pattern by dry-etching the charge-transporting layer using the photoresist pattern as an etching mask; and removing the photoresist pattern.

The charge-transporting complex may include a silicone (-Si-O-Si-) network structure, wherein the silicone (-Si-O-Si-) network structure is one of a silicone (-Si-O-Si-)-integrated Single Phase Network (SPN) and a silicone (-Si-O-Si-)-integrated Interpenetrating Polymer Network (IPN).

In the forming of the charge-transporting layer, at least two sub-charge transport layers having different organic silica precursor concentrations may be formed on the substrate.

In the forming of the charge-transporting layer pattern, a non-volatile blocking layer may be formed on a side surface of the charge-transporting layer pattern due to the silicone (-Si-O-Si-) network structure of the charge-transporting complex.

The non-volatile blocking layer may include at least one of SixOy and SixOyFz where x, y and z are integers from 1 to 4.

The charge-transporting layer pattern may have a size of 10 nm to 1000 µm.

In accordance with another aspect of the present invention, provided is an organic light-emitting device, including: a first electrode formed on a substrate; an organic light-emitting layer formed on the first electrode; a second electrode formed on the organic light-emitting layer; and a charge-transporting layer formed at at least one of an interface between the first electrode and the organic light-emitting layer and an interface between the organic light-emitting layer and the second electrode, and configured to include the charge-transporting complex according to one of claims 1 to 9.

Luminescence intensity and durability of the charge-transporting layer may be adjusted depending upon a concentration of the organic silica precursor.

The charge-transporting layer may include at least two sub-charge transport layers having different organic silica precursor concentrations.

A first sub-charge transport layer and a second sub-charge transport layer may be included at an interface between the first electrode and organic light-emitting layer of the charge-transporting layer, wherein a concentration of an organic silica precursor in the second sub-charge transport layer is higher than that of the first sub-charge transport layer.

In accordance with another aspect of the present invention, provided is a charge-transporting layer composition, including: a curable organic semiconductor; and organic silica precursor.

The charge-transporting layer composition may include: the curable organic semiconductor in an amount of 92.87 % by weight to 98.60 % by weight, and the organic silica precursor in an amount of 1.40 % by weight to 7.13 % by weight.

### [Advantageous effects]

In accordance with embodiments of the present invention, the present invention can provide a charge-transporting complex with a silicone (-Si-O-Si-) network which is based on a commercially available charge-transporting layer material and which can be directly applied to photolithography and a dry etching method, which are established ultra-high-resolution pattern technologies, due to secured high durability (chemical resistance and etching resistance); a method for high-resolution patterning of a charge-transporting layer including the charge-transporting complex, a charge-transporting layer composition including the charge-transporting complex, and an organic light-emitting device including the charge-transporting complex.

In particular, according to embodiments of the present invention, the present invention can provide a charge-transporting complex capable of simultaneously increasing chemical resistance and etching resistance without deteriorating the optoelectronic properties by implementing a silicone (-Si-O-Si-) network by a simultaneous curing reaction or cross-curing reaction between small-molecule organic semiconductor and organic silica precursor to be introduced, a method for high-resolution patterning of a charge-transporting layer including the charge-transporting complex, a charge-transporting layer composition including the charge-transporting complex, and an organic light-emitting device including the charge-transporting complex.

Further, according to embodiments of the present invention, the present invention can provide a charge-transporting complex that can secure chemical resistance/etch resistance and improve luminous efficiency by introducing an organic silica precursor, capable of forming a silicone (-Si-O-Si-) network through a cross-linking reaction with an organic semiconductor, to a curable small-molecule organic semiconductor, a method for high-resolution patterning of a charge-transporting layer including the charge-transporting complex, a charge-transporting layer composition including the charge-transporting complex, and an organic light-emitting device including the charge-transporting complex.

### [Description of Drawings]

FIG. 1a illustrates the schematic diagram of a charge-transporting complex according to an embodiment of the present invention, and FIG. 1b illustrates the schematic diagram of an organic silica precursor.
FIG. 2 illustrates the schematic diagram of a patterning method for a charge-transporting layer according to an embodiment of the present invention.
FIG. 3a illustrates a schematic diagram for comparing a wet-etching process for an existing hole-transporting layer and a dry-etching process of a patterning method for a charge-transporting layer according to an embodiment of the present.
FIG. 3b illustrates schematic diagrams for comparing charge-transporting layer patterns by a patterning method of the existing hole-transporting layer and the charge-transporting layer according to an embodiment of the present invention.
FIG. 4 illustrates the sectional view of an organic light-emitting device according to an embodiment of the present invention.
FIG. 5 illustrates the results of Fourier-transform infrared spectroscopy (FT-IR) analysis for the crosslinking reaction of the charge-transporting complex according to Example 1.
FIG. 6 illustrates the results of Time-of-Flight Secondary Ion Mass Spectrometry (ToF-SIMS) analysis for the hole-transporting layer including QUPD (X-QUPD) and the charge-transporting complex (SPN-QUPD) according to Example 1.
FIG. 7 illustrates an Atomic Force Microscope (AFM) measurement image of the hole-transporting layer including QUPD (X-QUPD) and the charge-transporting complex (SPN-QUPD) according to Example 1.
FIG. 8 illustrates the charge-transporting layer pattern of a hole-transporting layer including the charge-transporting complex (SPN-QUPD) according to Example 1.
FIG. 9 illustrates the widths and heights of high-resolution patterns of a hole-transporting layer including the charge-transporting complex (SPN-QUPD) according to Example 1, FIG. 10 illustrates chemical resistance test results, and FIG. 11 illustrates etch resistance test results.
FIG. 12 illustrates the schematic diagrams and energy band diagrams of the organic light-emitting devices (Examples 2-1, 2-2 and 2-3) in which the charge-transporting complexes (SPN 4 mol%, 8 mol%, 16 mol%) according to Example 1 with different organic silica precursor concentrations are included in the hole-transporting layers.
FIG. 13 illustrates ultraviolet photoelectron spectroscopy (UPS) spectra, FIG. 14 illustrates absorbances, and FIG. 15 illustrates band gaps (energy gaps) through a Tauc plot.
FIG. 16 illustrates the voltage-dependent current density and brightness of each of the organic light-emitting device according to the comparative example and the organic light-emitting devices according to Examples 2-1 to 2-3, FIG. 17 illustrates brightness-dependent power efficiency and external quantum efficiency, FIG. 18 illustrates brightness-dependent power efficiency, and FIG. 19 illustrates the brightness and maximum quantum efficiency dependent upon the content of the organic silica precursor.
FIG. 20 illustrates the schematic diagram and energy band diagram of the organic light-emitting device according to Example 3.
FIG. 21 illustrates the voltage-dependent current density and brightness of each of the organic light-emitting device according to Example 2-1 and the organic light-emitting device according to Example 3, FIG. 22 illustrates graphs for comparing brightness-dependent power efficiency and external quantum efficiency, FIG. 23 illustrates graphs for comparing brightness-dependent power efficiency, and FIG. 24 illustrates graphs for comparing brightness and maximum quantum efficiency.

### [Best Mode]

The present invention will now be described more fully with reference to the accompanying drawings and contents disclosed in the drawings. However, the present invention should not be construed as limited to the exemplary embodiments described herein.

The terms used in the present specification are used to explain a specific exemplary embodiment and not to limit the present inventive concept. Thus, the expression of singularity in the present specification includes the expression of plurality unless clearly specified otherwise in context. It will be further understood that the terms "comprise" and/or "comprising", when used in this specification, specify the presence of stated components, steps, operations, and/or elements, but do not preclude the presence or addition of one or more other components, steps, operations, and/or elements thereof.

It should not be understood that arbitrary aspects or designs disclosed in "embodiments", "examples", "aspects", etc. used in the specification are more satisfactory or advantageous than other aspects or designs.

In addition, the expression "or" means "inclusive or" rather than "exclusive or". That is, unless mentioned otherwise or clearly inferred from context, the expression "x uses a or b" means any one of natural inclusive permutations.

In addition, as used in the description of the disclosure and the appended claims, the singular form "a" or "an" is intended to include the plural forms as well, unless context clearly indicates otherwise.

Although terms used in the specification are selected from terms generally used in related technical fields, other terms may be used according to technical development and/or due to changes, practices, priorities of technicians, etc. Therefore, it should not be understood that terms used below limit the technical spirit of the present invention, and it should be understood that the terms are exemplified to describe embodiments of the present invention.

Also, some of the terms used herein may be arbitrarily chosen by the present applicant. In this case, these terms are defined in detail below. Accordingly, the specific terms used herein should be understood based on the unique meanings thereof and the whole context of the present invention.

Meanwhile, terms such as "first" and " second" are used herein merely to describe a variety of constituent elements, but the constituent elements are not limited by the terms. The terms are used only for the purpose of distinguishing one constituent element from another constituent element.

In addition, when an element such as a layer, a film, a region, and a constituent is referred to as being "on" another element, the element can be directly on another element or an intervening element can be present.

Unless defined otherwise, all terms (including technical and scientific terms) used herein have the same meaning as commonly understood by one of ordinary skill in the art. It will be further understood that terms, such as those defined in commonly used dictionaries, should be interpreted as having a meaning that is consistent with their meaning in the context of the relevant art and the present invention, and will not be interpreted in an idealized or overly formal sense unless expressly so defined herein.

In addition, in the following description of the present invention, a detailed description of known functions and configurations incorporated herein will be omitted when it may make the subject matter of the present invention unclear. The terms used in the specification are defined in consideration of functions used in the present invention, and can be changed according to the intent or conventionally used methods of clients, operators, and users. Accordingly, definitions of the terms should be understood on the basis of the entire description of the present specification.

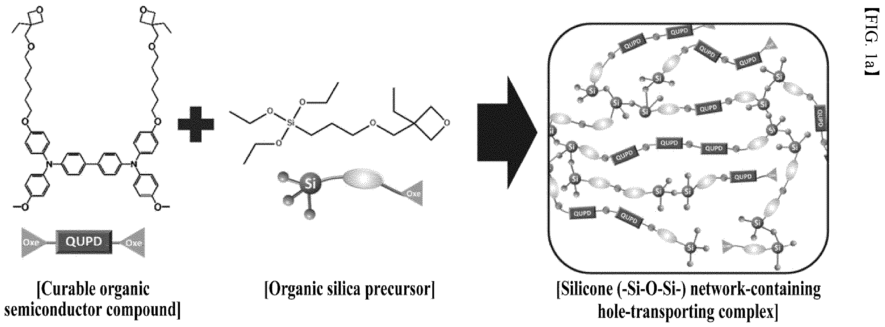

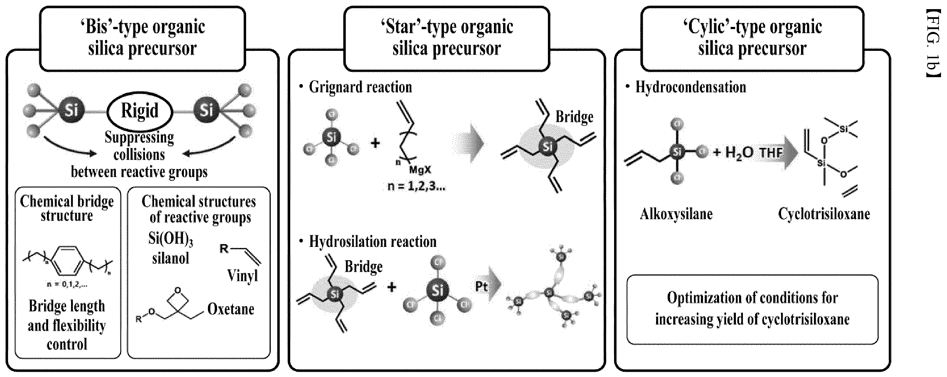

FIG. 1a illustrates the schematic diagram of a charge-transporting complex according to an embodiment of the present invention, and FIG. 1b illustrates the schematic diagram of an organic silica precursor.

An organic light-emitting device (OLED) is attracting attention as a next-generation display technology that can be effectively applied to ultra-realistic and immersive VR/AR/MR/XR microdisplays for realistic content and real metaverse technology due to its advantages such as excellent color reproducibility, fast response speed, wide viewing angle, and low power consumption. Accordingly, the development of ultra-high-resolution full-color OLED displays in which each R/G/B subpixel is directly patterned is actively underway.

As the resolution of full-color OLED (over 300 PPI) increases, the spacing between R/G/B subpixels gets closer, causing leakage current between adjacent pixels along a charge-transporting layer formed as a common layer in the OLED device, which reduces pixel sharpness and color reproducibility. This pixel crosstalk phenomenon may be further aggravated when implementing ultra-high-resolution (over 3,000 PPI) full-color OLED for microdisplays. Therefore, there is an urgent need for a design of charge-transporting layer materials capable of forming ultra-fine patterns and an ultra-high-resolution pattern process methodology.

The charge-transporting complex according to an embodiment of the present invention can implement an ultra-high-resolution pattern based on general-purpose photolithography and a dry-etching process by applying an organic silica precursor capable of forming a silicone (-Si-O-Si-) network to a low-molecular-weight curable organic semiconductor material having excellent charge-conducting properties which is used as a common layer of an organic light-emitting device to simultaneously enhance the chemical resistance and etch resistance of the low-molecular-weight curable organic semiconductor.

More specifically, the charge-transporting complex according to an embodiment of the present invention includes a curable organic semiconductor; and an organic silica precursor that forms a silicone (-Si-O-Si-) network structure together with the curable organic semiconductor. The curable organic semiconductor includes a cross-linking functional group, and an SPN or IPN in which silicone (-Si-O-Si-) is bonded may be formed through a simultaneous or cross-curing reaction between the cross-linking functional group of the curable organic semiconductor and the organic silica precursor.

Accordingly, the charge-transporting complex according to an embodiment of the present invention may implement ultra-fine patterns through the direct application of general-purpose photolithography and a dry-etching process, which are established ultra-high-resolution pattern technologies, by introducing the silicone (-Si-O-Si-) network into a commercially available charge-transporting layer material to secure high durability (chemical resistance and etch resistance) and luminescence characteristics.

That is, the charge-transporting complex according to an embodiment of the present invention may be effectively applied to microdisplays, small high-resolution full-color OLED display panels, etc., where high resolution is required and crosstalk between pixels may occur.

Hereinafter, the respective components of the charge-transporting complex according to an embodiment of the present invention are described in detail.

The charge-transporting complex according to an embodiment of the present invention includes a curable organic semiconductor including a cross-linking functional group.

The curable organic semiconductor may include a charge-transporting compound (at least one of a hole-transporting compound and an electron-transporting compound) to which a cross-linking functional group is bonded, and, for example, the curable organic semiconductor may be represented by Formula 1 below:

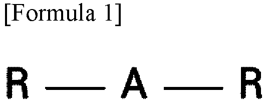

(In Formula 1, A is a hole-transporting compound or an electron-transporting compound, and R is a cross-linking functional group.)

As the cross-linking functional group of the curable organic semiconductor is bonded to the hole-transporting compound or the electron-transporting compound, the curable organic semiconductor is crosslinked with the organic silica precursor by a curing reaction, thereby forming a silicone (-Si-O-Si-) network structure.

The position of the cross-linking functional group bonded to the hole-transporting compound or the electron-transporting compound is not particularly limited.

The curable organic semiconductor is a hole-transporting compound having a cross-linking functional group bonded thereto, and the hole-transporting compound may include at least one of a triphenyl amine derivative, an aromatic diamine derivative, an arylene diamine-based derivative, a carbazole derivative, a spiro-arylene diamine derivative, a starburst-type amine-based derivative, a triarylamine derivative, a thiophene derivative, and a triarylphosphine derivative.

Preferably, the curable organic semiconductor may include at least one of N4,N4'-bis(4-(6-((3-ethyloxetan-3-yl)methoxy)hexyloxy)phenyl)-N4,N4'-bis(4-methoxyphenyl)biphenyl-4,4'-diamine (QUPD), N4,N4'-bis(4-(6-((3-ethyloxetan-3-yl)methoxy)hexyl)phenyl)-N4,N4'-diphenylbiphenyl-4,4'-diamine (OTPD), oxe-DCDPA(N,N-bis(4-(6-((3-ethyloxetane-3-yl)methoxy)hexyloxy)phenyl)-3,5-di(9H-carbazol-9-yl)benzenamine), vinylbenzyl (VB)-TCTA (tris(4-carbazoyl-9-ylphenyl)amine), N,N'-bis(tolyl)-N,N'-bis(vinylphenyl)-1,1'-biphenyl-4,4'-diamine (DV-TPD), tris[(p-trifluorovinyloxy-biphenyl)]amine (TPA-TFVE), MUPD and AUPD, and more preferably the curable organic semiconductor may be N4,N4'-bis(4-(6-((3-ethyloxetan-3-yl)methoxy)hexyloxy)phenyl)-N4,N4'-bis(4-methoxyphenyl)biphenyl-4,4'-diamine (QUPD).

N4,N4'-bis(4-(6-((3-ethyloxetan-3-yl)methoxy)hexyloxy)phenyl)-N4,N4'-bis(4-methoxyphenyl)biphenyl-4,4'-diamine (QUPD) may be represented by Formula 2 below:

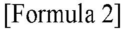

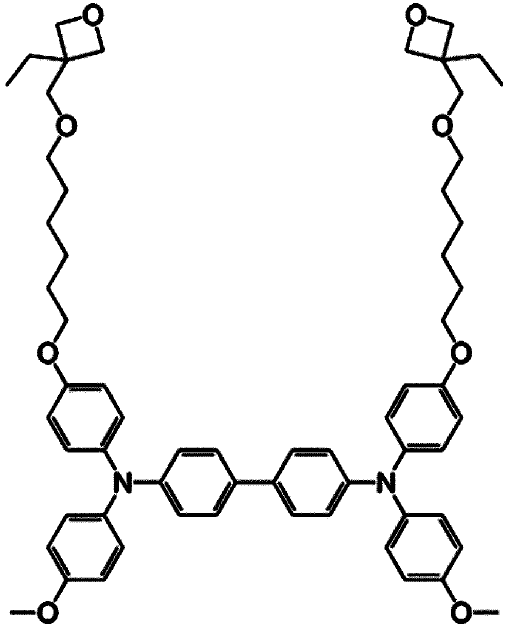

In addition, the curable organic semiconductor is an electron-transporting compound having the cross-linking functional group bonded thereto, and the electron-transporting compound may include at least one of an oxadiazole derivative, a triazole derivative, a phenanthroline derivative, a benzoxazole derivative, a benzothiazole derivative, a benzimidazole derivative, a triazine derivative, a benzoquinone derivative, a pyridine derivative, an anthraquinone derivative, a polyquinoline derivative, and a polyfluorene derivative.

The curable organic semiconductor may include at least one of 4,6-bis[4-(5-{4-[(4-vinylbenzyloxy)methyl]phenyl}-4-(4-tert-butyl-phenyl)-4H-1,2,4-triazol-3-yl)phenyl]-2-methylpyrimidie (DV-46PymTAZ), SMH-E-10, 1,3,5-tris(5(4-vinylphenyl)pyridin-3-yl)benzene (TV-TmPY) and U-BmPyPB.

The cross-linking functional group may include at least one of a vinyl group, a vinyl derivative, an oxetane group, a boronic acid group, trifluoro vinyl ether, benzocyclobutene and epoxide.

Preferably, the cross-linking functional group may include a functional group represented by one of Formulas 3 to 8:

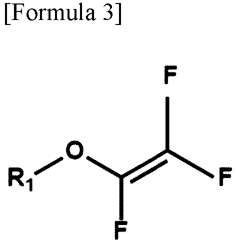

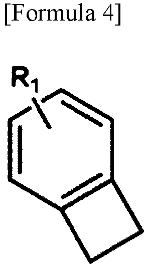

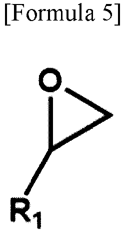

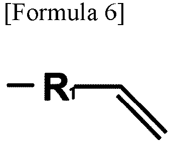

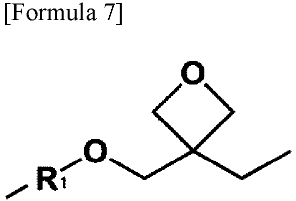

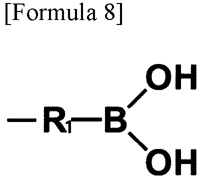

(In Formulas 3 to 8, R₁ each independently includes one of a hydrogen, a heavy hydrogen, a cyano group, a halogen group, an amino group, a thiol group, a hydroxy group, a nitro group, a carbonyl group, an ether group, a silane group, a siloxane group, a substituted or unsubstituted alkyl group having 1 to 20 carbon atoms, a substituted or unsubstituted cycloalkyl group having 3 to 20 carbon atoms, a substituted or unsubstituted alkenyl group having 2 to 20 carbon atoms, a substituted or unsubstituted alkynyl group having 2 to 20 carbon atoms, a halogenated alkyl group having 1 to 20 carbon atoms, a substituted or unsubstituted fluorenyl group, a substituted or unsubstituted aryl group having 6 to 30 carbon atoms, a substituted or unsubstituted aryloxy group having 6 to 30 carbon atoms, a substituted or unsubstituted alkoxy group having 1 to 20 carbon atoms, a substituted or unsubstituted alkylsilyl group having 1 to 20 carbon atoms, a substituted or unsubstituted arylsilyl group having 6 to 30 carbon atoms, a substituted or unsubstituted arylalkyl group having 7 to 30 carbon atoms, a substituted or unsubstituted alkenyloxyl group having 2 to 30 carbon atoms, a substituted or unsubstituted aryl group having 8 to 30 carbon atoms alkenylaryl group, a substituted or unsubstituted arylalkoxy group having 7 to 30 carbon atoms, a substituted or unsubstituted arylalkenyl group having 8 to 30 carbon atoms and a substituted or unsubstituted alkoxycarbonyl group having 2 to 20 carbon atoms.

According to an embodiment, the cross-linking functional group may include, without being limited to, a functional group that undergoes a spontaneous polymerization reaction upon stimulation by heat and light irradiation.

The charge-transporting complex according to an embodiment of the present invention may form a charge-transporting layer through a solution process by introducing various cross-linking functional groups into the curable organic semiconductor, and may implement the chemical resistance of the charge-transporting layer by irradiating it with heat or UV.

The charge-transporting complex according to an embodiment of the present invention includes an organic silica precursor that forms a silicone (-Si-O-Si-) network structure together with the curable organic semiconductor.

The organic silica precursor may include at least one of a bis-type organic silica precursor, star-type organic silica precursor and cyclic-type organic silica precursor as shown in FIG. 1b.

In the charge-transporting complex according to an embodiment of the present invention, the crosslinking reaction may proceed in the same manner if curing functional groups (e.g., a cross-linking functional group) introduced into the bis-type/star-type/cyclic-type organic silica precursor are the same, but the organic silica precursor may be appropriately selected depending upon the purpose.

More specifically, to effectively constitute a silicone (-Si-O-Si-) network by inducing a crosslinking reaction between a curable small-molecule charge-transporting compound (a hole-transporting compound or an electron-transporting compound)-organic silica precursor or between precursor molecules, i) a crosslinking reaction in the molecules of the organic silica precursor should be suppressed as much as possible, and ii) an effective silicone (-Si-O-Si-) network should be formed using a minimum content of an organic silica precursor as an insulator.

In the case of the bis-type organic silica precursor, a crosslinking reaction between organic silica precursor molecules may be effectively induced when the number of alkyl chains in its bridge chain is 5 or more or a rigid chemical structure such as benzene is introduced, and in the case of the star-type/cyclic-type organic silica precursor, a high-density silicone (-Si-O-Si-) network may be formed even using a minimum content because an organic silica precursor molecule contains three or more cross-linking functional group.

For example, the organic silica precursor may include a compound represented by one of Formulas 12 to 22 below:

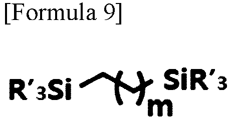

(In Formula 9, R' includes one to three halogen elements or one to three alkoxy (-O-(CH₂)ₓ-CH₃, where X is an integer of 0 to 8.), and m is an integer of 0 to 20.) 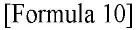 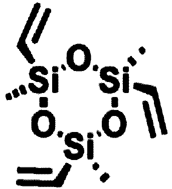 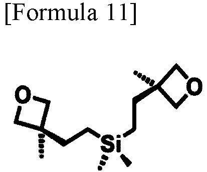 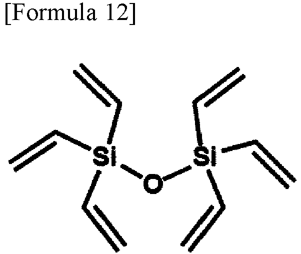 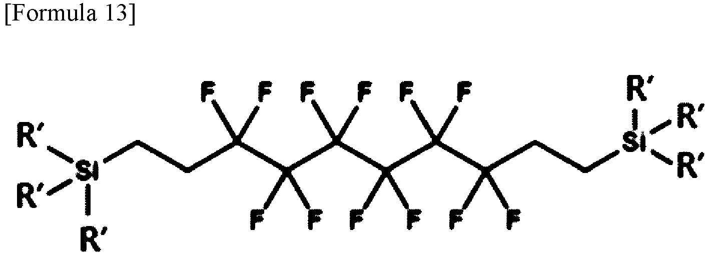 (In Formula 13, R' includes one to three halogen elements or one to three alkoxy (-O-(CH₂)ₓ-CH₃, where X is an integer from 0 to 8)

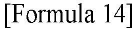

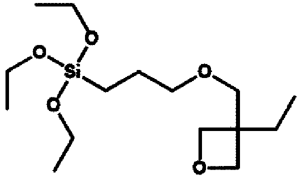

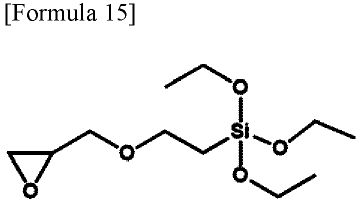

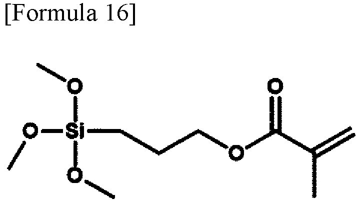

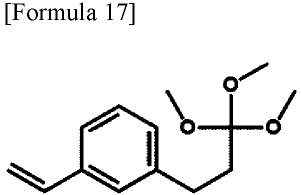

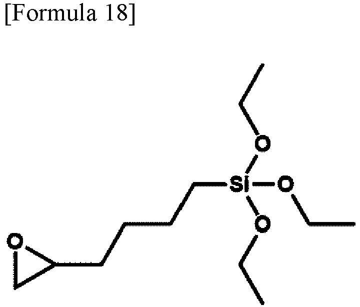

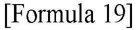

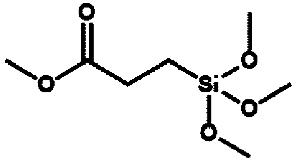

For example, Formula 9 may include a compound represented by Formula 9-1 below, and Formula 13 may include a compound represented by Formula 13-1 below.

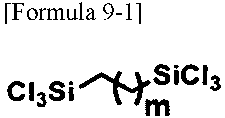

(In Formula 9-1, m is an integer from 0 to 20.)

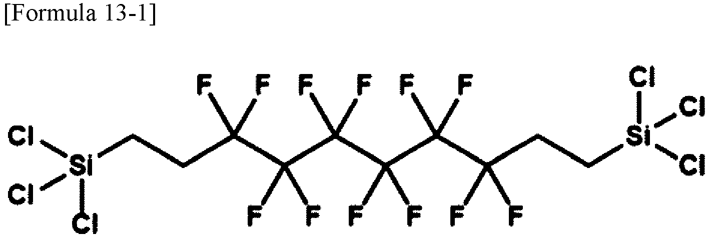

The organic silica precursor represented by Formula 12 is hexavinyldisiloxane, the organic silica precursor represented by Formula 13 is 1,6-bis(trichlorosilylethyl)dodecafluorohexane, the organic silica precursor represented by Formula 14 is 3-ethyl-3-[[3-(triethoxysilyl)propoxy]methyl]oxetane, the organic silica precursor represented by Formula 15 is 3-glycidyloxypropyl)triethoxysilane, the organic silica precursor represented by Formula 16 is 3-(trimethoxysilyl)propyl methacrylate, the organic silica precursor represented by Formula 17 is 2-(2-ethenylphenyl)ethyl-trimethoxysilane, the organic silica precursor represented by Formula 18 is 5,6-epoxyhexyltriethoxysilane, and the organic silica precursor represented by Formula 19 is 2-(carbomethoxy)ethyltrimethoxysilane.

The charge-transporting complex according to an embodiment of the present invention may have a network structure including a structure represented by Formula 20 below due to the silicone (-Si-O-Si-) contained in the organic silica precursor:

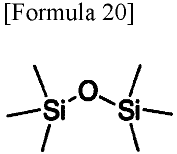

Accordingly, the silicone (-Si-O-Si-)-integrated network may be implemented through a simultaneous curing reaction or cross-curing reaction between the curable organic semiconductor, which is a small-molecule charge-transporting compound having a cross-linking functional group introduced thereinto, and the organic silica precursor, thereby simultaneously enhancing chemical resistance and etch resistance without deteriorating the optoelectronic properties.

Furthermore, the charge-transporting complex according to an embodiment of the present invention may secure chemical resistance through the silicone (-Si-O-Si-)-integrated network, and since the material itself can form a non-volatile blocking layer through a chemical reaction between silicone molecules, which exist in the network, and a dry etching gas, etch resistance may also be implemented at the same time.

Preferably, the network may be a silicone (-Si-O-Si-)-integrated Single Phase Network (SPN) or a silicone (-Si-O-Si-)-integrated Interpenetrating Polymer Network (IPN), and the above-described two silicone (-Si-O-Si-) networks may be formed by simultaneously or selectively curing depending upon cross-linking functional groups contained in the curable organic semiconductor.

That is, a charge-transporting complex having high durability (etch resistance and chemical resistance) may be formed by adjusting the mutual crosslinking reaction between the charge-transporting compound (curable organic semiconductor) having a cross-linking functional group introduced thereinto and the organic silica precursor.

For example, when the curable organic semiconductor includes a first cross-linking functional group, the organic silica precursor includes a second cross-linking functional group, and the first cross-linking functional group is the same as the second cross-linking functional group, the charge-transporting complex according to an embodiment of the present invention may have a Single Phase Network (SPN) structure, to which silicone (-Si-O-Si-) having both the curable organic semiconductor and organic silica precursor connected thereto is bonded, by inducing a simultaneous curing reaction between the curable organic semiconductor and the organic silica precursor.

Accordingly, the silicone (-Si-O-Si-)-integrated SPN may be formed by a simultaneous crosslinking reaction of the curable organic semiconductor and the organic silica precursor.

For example, when the curable organic semiconductor includes the first cross-linking functional group, the organic silica precursor includes the second cross-linking functional group, and the first cross-linking functional group differs from the second cross-linking functional group, the curing reaction between the curable organic semiconductor including the first cross-linking functional group and the selective curing reaction between the organic silica precursor may be each independently induced, so that the charge-transporting complex according to an embodiment of the present invention may have a silicone (-Si-O-Si-)-integrated Interpenetrating Polymer Network (IPN) structure in which the silicone (-Si-O-Si-) network (organic silica precursor) due to the curable organic semiconductor and the organic silica precursor is physically entangled.

Accordingly, the silicone (-Si-O-Si-)-integrated IPN may be formed by the crosslinking reaction between the curable organic semiconductor and the selective crosslinking reaction between the organic silica precursor.

In addition, when the charge-transporting complex according to an embodiment of the present invention contains the organic silica precursor, the silicone (-Si-O-Si-) network may be formed even when the organic silica precursor is added in a small amount, so that high durability (chemical resistance and etching resistance) may be effectively improved. Accordingly, to manufacture the charge-transporting complex according to an embodiment of the present invention, the structure (SPN), in which the silicone (-Si-O-Si-) network is directly connected to the curable organic semiconductor, or the structure (IPN), in which the networks are physically entangled, may be flexibly selected depending upon the type of the cross-linking functional group.

Accordingly, since the structure (SPN), in which the silicone (-Si-O-Si-) network is directly connected to the curable organic semiconductor, or the structure (IPN), in which the networks are physically entangled, may be selected depending upon the type of the cross-linking functional group to manufacture the charge-transporting complex according to an embodiment of the present invention, various charge-transporting compounds (if a cross-linking functional group is bonded thereto, charge-transporting compound materials are not limited) and organic silica precursors may be used without limitation. Accordingly, the material group range is wide, so the material versatility is excellent.

In addition, the charge-transporting complex according to an embodiment of the present invention may secure chemical resistance and etching resistance through a molecular structure in which a silicone (-Si-O-Si-)-integrated network is three-dimensionally entangled, thereby enabling high-resolution pattern implementation through a photolithography process.

The charge-transporting complex according to an embodiment of the present invention may simultaneously enhance the chemical resistance and etch resistance of the small-molecule curable organic semiconductor, thereby enabling direct application of photolithography and dry etching, which are ultra-high-resolution pattern technologies, to an organic light-emitting material to implement an ultra-fine pattern at the level of several micrometers or less. Accordingly, the organic light-emitting composite may be effectively applied to microdisplays, head-up displays, and ultra-high-resolution OLEDs for mobile devices which require both excellent luminous efficiency and ultra-high resolution.

Accordingly, since an ultra-high-resolution full-color OLED display with suppressed pixel-to-pixel crosstalk phenomenon can be developed using the charge-transporting complex according to an embodiment of the present invention, it can be applied to VR/AR/MR/XR device technology and visual interface technology for metaverse (augmented five senses). Furthermore, the charge-transporting complex according to an embodiment of the present invention is not limited to a charge-transporting layer for OLEDs, but may be extended to small-molecule organic semiconductors for various electronic devices, and thus may be applied to next-generation organic electronic devices, such as neuromorphic devices and image sensors, which require high-resolution patterns of organic semiconductors.

Furthermore, the charge-transporting complex according to an embodiment of the present invention may realize an ultra-fine pattern (2 µm or less) based on photolithography and a dry-etching process through the secured high durability (chemical resistance and etch resistance), and may also improve the optoelectronic properties of the organic light-emitting device by reducing the energy level difference between organic light-emitting bodies and increasing the charge transfer efficiency to an organic light-emitting layer.

Accordingly, the charge-transporting complex according to an embodiment of the present invention may improve the performance of an organic light-emitting device through a charge-transporting layer material, to which a silicone (-Si-O-Si-) network is introduced, using a curable small-molecule organic semiconductor and an organic silica precursor, and at the same time, the ultra-fine pattern of a charge-transporting layer may be implemented by photolithography and a dry-etching process which are established ultra-high-resolution pattern technologies.

The luminescence intensity and durability of the charge-transporting complex according to an embodiment of the present invention may be controlled depending upon the concentration of the organic silica precursor.

As the concentration of the organic silica precursor increases, the energy level (HOMO level) of the charge-transporting complex shifts toward a deep level, thereby inducing a decrease in the energy level (HOMO level) difference of the organic light-emitting layer. Accordingly, the efficiency of the charge transfer to the organic light-emitting layer may be improved, so that the EQE and luminous efficiency of the organic light-emitting device may be effectively improved.

In addition, as the concentration of the organic silica precursor increases, the durability (etch resistance and chemical resistance, etc.) of the charge-transporting complex may be improved, and an ultra-fine pattern that is more uniform than existing cases may be obtained.

However, when the organic silica precursor, which is an insulating material, is included in an excessive amount, the charge trap phenomenon inside the charge-transporting complex may increase, which may decrease the charge transfer efficiency. In addition, the lowest occupied molecular orbital level (LUMO level) of the charge-transporting complex may become similar to the lowest occupied molecular orbital level (LUMO level) of the organic light-emitting layer, so that electrons of an organic light-emitting layer may move toward the charge-transporting complex, which may decrease the luminous efficiency. In addition, when the content of the organic silica precursor is small, sufficient durability cannot be secured, making it difficult to implement an ultra-fine pattern. Accordingly, appropriate content control is required.

In addition, the charge-transporting complex according to an embodiment of the present invention may be provided in the form of a composition.

The charge-transporting layer according to an embodiment of the present invention composition includes a curable organic semiconductor and an organic silica precursor.

The charge-transporting layer according to an embodiment of the present invention composition includes the same components as in the charge-transporting complex according to an embodiment of the present invention, so descriptions of the same components are omitted.

The concentration of the curable organic semiconductor is not limited to the concentrations described above, and may be adjusted depending the type of the cross-linking functional group.

For example, when an oxetane group is included as the cross-linking functional group, the charge-transporting layer composition may include 92.87 % by weight to 98.60 % by weight of the curable organic semiconductor and 1.40 % by weight to 7.13 % by weight of the organic silica precursor based on the total weight of the charge-transporting layer composition.

The luminescence intensity and durability of the charge-transporting complex according to an embodiment of the present invention may be adjusted depending upon the concentration of the organic silica precursor.

More specifically, the etch resistance of the charge-transporting layer according to an embodiment of the present invention composition may be adjusted depending upon the concentration of the organic silica precursor.

For example, as the concentration of the organic silica precursor increases, the number of silicone molecules per unit volume of the charge-transporting layer increases, so that the etch resistance may increase. However, since the OLED device characteristics may decrease as the concentration increases due to the insulating properties of the organic silica precursor, the concentration should be appropriately controlled.

Depending upon an embodiment, the charge-transporting layer according to an embodiment of the present invention composition may further include a residual amount of organic solvent.

The solvent is not particularly limited, but, for example, the solvent may include at least one of an alcohol-based solvent, a halogen-containing solvent, a hydrocarbon-based solvent, a ketone-based solvent, an ester-based solvent, and an amide-based solvent.

Examples of the alcohol-based solvent may include at least one of methanol, ethanol, propan-1-ol, butan-1-ol, pentan-1-ol, hexan-1-ol, heptan-1-ol, octan-1-ol, nonan-1-ol, decan-1-ol, undecan-1-ol, dodecan-1-ol, tridecan-1-ol, tetradecan-1-ol, pentadecan-1-ol, hexadecan-1-ol, heptadecan-1-ol, octadecan-1-ol, nonadecan-1-ol, eicosan-1-ol, hen-eicosan-1-ol, docosan-1-ol, tricosan-1-ol, tetracosan-1-ol, pentacosan-1-ol, hexacosan-1-ol, heptacosan-1-ol, octacosan-1-ol, nonacosan-1-ol, triacontan-1-ol, policosanol, 2-methyl: 2-methylpropan-1-ol, 3-methyl: 3-methylbutan-1-ol, propan-2-ol, butan-2-ol, pentan-2-ol, hexan-2-ol, heptan-2-ol, 2-methyl: 2-methylbutan-1-ol, cyclohexanol, 2-methyl: 2-methylpropan-2-ol, 2-mhylbutan-2-ol, 2-methylpentan-2-ol, 2-methylhexan-2-ol, 2-methylheptan-2-ol, and 3-methyl: 3-methylpentan-3-ol and 3-methyloctan-3-ol.

The halogen-containing solvent may include at least one of chlorobenzene, chloroform, tetrafluorodibromo ethylene, trichloroethylene, tetrachloroethylene, trifluorochloroethylene, 1,2,4-trichlorobenzene, carbon tetrachloride, dichloromethane and dichloroethane, dichlorobenzene.

The hydrocarbon-based solvent may include at least one of octane, nonane, decane, undecane, toluene, xylene, ethylbenzene, n-propylbenzene, iso-propylbenzene, mesitylene, n-butylbenzene, sec-butylbenzene, 1-phenylpentane, 2-phenylpentane, 3-phenylpentane, henylcyclopentane, phenylcyclohexane, 2-ethylbiphenyl and 3-ethylbiphenyl.

The ether-based solvent may include at least one of 1,4-dioxane, 1,2-diethoxyethane, diethyleneglycoldimethylether, diethyleneglycoldiethylether, anisole, ethoxybenzene, 3-methylanisole and m-dimethoxybenzene.

The ketone-based solvent may include at least one of 2-hexanone, 3-hexanone, cyclohexanone, 2-heptanone, 3-heptanone, 4-heptanone and cycloheptanone.

The ester-based solvent may include at least one of butylacetate, butylpropionate, heptylbutyrate, propylenecarbonate, methylbenzoate, ethylbenzoate, 1-propylbenzoate and 1-1-butylbenzoate.

The amide-based solvent may include at least one of dimethylformamide, dimethylacetamide and N-methylpyrrolidone.

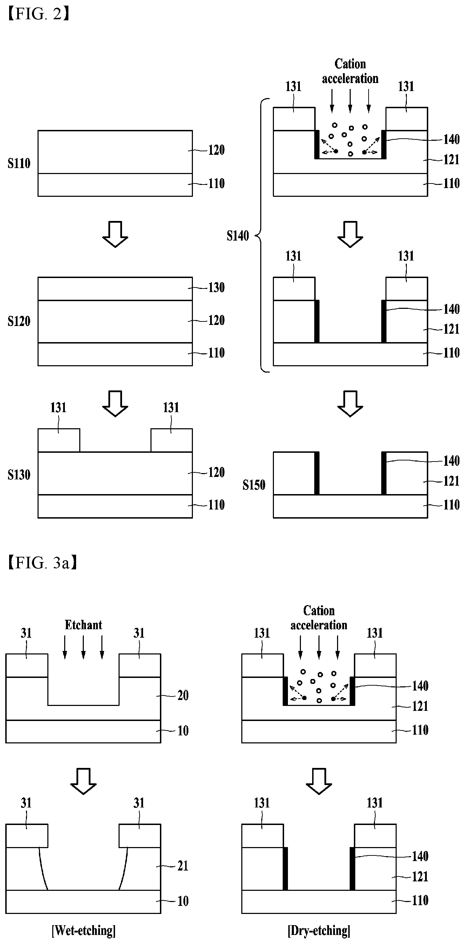

FIG. 2 illustrates the schematic diagram of a patterning method for a charge-transporting layer according to an embodiment of the present invention.

First, the patterning method for the charge-transporting layer according to an embodiment of the present invention includes a step S110 of forming a charge-transporting layer 120, which includes the charge-transporting complex according to an embodiment of the present invention, on a substrate 110.

The substrate 110 may be an inorganic substrate or an organic substrate.

The inorganic substrate may include at least one of glass, quartz, Al₂₀₃, SiC, Si, GaAs and InP.

The organic substrate may include at least one of Kapton foil, polyethylene terephthalate (PET), polyimide (PI), polydimethylsiloxane (PDMS), polyethersulfone (PES), polyacrylate (PAR), polyetherimide (PEI), polyethylene naphthalate (PEN), polyphenylene sulfide (PPS), polyarylate, polycarbonate (PC), cellulose triacetate (CTA) and cellulose acetate propionate (CAP).

According to an embodiment, the patterning method for the charge-transporting layer according to an embodiment of the present invention may include a step of performing ultraviolet-ozone treatment to form a hydrophilic group on the surface of the substrate 110.

By the ultraviolet-ozone treatment, a hydrophilic group is formed on the surface of the substrate 110, thereby improving the surface adhesion between the substrate 110 and the charge-transporting layer 120 to be formed in a subsequent process.

The hydrophilic group may be at least one of a -OH group, a -OOH group and a -OO-group, and preferably, the hydrophilic group may be a -OH group.

According to an embodiment, the patterning method for the charge-transporting layer according to an embodiment of the present invention may further include forming a multilayer film between the substrate 110 and the charge-transporting layer 120, and the multilayer film may include at least one of a first electrode, a hole-injecting layer, a hole-transporting layer, a hole-blocking layer, an organic light-emitting layer, an electron-transporting layer, an electron-injecting layer, an electron-blocking layer and a second electrode.

The charge-transporting layer 120 may be formed by coating with a coating solution including the charge-transporting complex according to an embodiment of the present invention.

The coating solution may include a charge-transporting complex and a solvent.

The charge-transporting complex and the solvent include the same components as in the charge-transporting complex according to an embodiment of the present invention described with reference to FIGS. 1a and 1b, so descriptions of the same components are omitted.

The charge-transporting complex may include a silicone (-Si-O-Si-) network structure, and the silicone (-Si-O-Si-) network structure may be one of a silicone (-Si-O-Si-)-integrated Single Phase Network (SPN) and a silicone (-Si-O-Si-)-integrated Interpenetrating Polymer Network (IPN).

The charge-transporting layer 120 may be coated by at least one method of spin coating, flexible coating, roll coating, slit and spin coating, slit coating, spray coating, roll to roll, bar coating, dip coating, casting, die coating, blade coating, gravure coating, and doctor coating.

According to an embodiment, the step S110 of forming a charge-transporting layer of the patterning method for the charge-transporting layer according to an embodiment of the present invention may further include a step of forming at least two sub-charge transport layers having different organic silica precursor concentrations on the substrate 110.

For example, the step S110 of forming a charge-transporting layer may include a step S111 of forming a first sub-charge transport layer on the substrate 110; and a step S112 of forming a second sub-charge transport layer on the first sub-charge transport layer.

The concentration of the organic silica precursor in the first sub-charge transport layer may differ from that of the second sub-charge transport layer, and the concentration of the organic silica precursor of the second sub-charge transport layer may be higher than that of the first sub-charge transport layer. Here, the first sub-charge transport layer is a charge-transporting layer in contact with the electrode, and the second sub-charge transport layer is a charge-transporting layer in contact with the organic light-emitting layer.

Since the luminescence intensity and durability of the charge-transporting layer can be adjusted depending upon the concentration of the organic silica precursor, the charge transfer efficiency may be improved by laminating the second sub-charge transport layer, which has a higher organic silica precursor concentration than the first sub-charge transport layer, on the first sub-charge transport layer to reduce a difference in energy levels (HOMO levels) between the first and second sub-charge transport layers and the organic light-emitting layer, thereby improving luminous efficiency while providing excellent durability in a subsequent solution process due to the organic silica precursor concentration of the second sub-charge transport layer.

Next, according to the patterning method for the charge-transporting layer according to an embodiment of the present invention, a step S120 of forming a photoresist 130 on the charge-transporting layer 120 is performed.

In the step S120, the photoresist 130 may be formed by applying a photoresist solution on the charge-transporting layer 120, followed by heating and drying (prebaking) the photoresist solution-applied substrate 110, or drying the photoresist solution-applied substrate 110 under reduced pressure and then heating the same.

The substrate 110 applied with the photoresist 130 may be heated to evaporate volatile components such as a solvent. Here, the heating temperature may be relatively low 70°C to 100°C, and the heating and drying (prebaking) may be performed at 110°C for 2 minutes.

The photoresist 130 may be coated by at least one method of spin coating, flexible coating, roll coating, slit and spin coating, slit coating, spray coating, roll to roll, bar coating, dip coating, casting, die coating, blade coating, gravure coating, and doctor coating.

Next, according to the patterning method for the charge-transporting layer according to an embodiment of the present invention, a step S130 of patterning the photoresist 130 to form a photoresist pattern 131 is performed.

In the step S130, the photoresist pattern 131 may be formed by exposing the photoresist 130 using a mask having a target pattern engraved thereon, and then performing a development process for the exposed photoresist 130 using a developing solution. For example, exposure may be performed by irradiating ultraviolet rays using a mask for forming a target pattern. When ultraviolet rays are irradiated to the photoresist 130, the chemical structure of the photoresist part irradiated with ultraviolet rays changes, so that it may be easily dissolved in a developer.

Next, according to the patterning method for the charge-transporting layer according to an embodiment of the present invention, a step S140 of dry-etching the charge-transporting layer 120 using a photoresist pattern 131 as an etching mask to form a charge-transporting layer pattern 121 is performed.

The charge-transporting layer 120 may be etched using an etching gas and washed to form the charge-transporting layer pattern 121.

The etching gas may include at least one of CF₄, Cl₂, BCl₃, HCl, HBr, NF₃ and SF₆. According to an embodiment, the etching gas may be a mixed gas containing at least one of Ar, He, O₂, and H₂.

In particular, when the charge-transporting layer 120 is exposed to an etching gas in the step S140 of dry-etching the charge-transporting layer 120 using a photoresist pattern 131 as an etching mask to form a charge-transporting layer pattern 121, the charge-transporting layer 120 is etched to form the charge-transporting layer pattern 121 and, at the same time, a non-volatile blocking layer 140 may be formed on a side surface of the charge-transporting layer pattern 121 due to the silicone (-Si-O-Si-) network structure of the charge-transporting complex.

The non-volatile blocking layer 140 may include at least one of SixOy and SixOyFz (x, y and z are an integer of 1 to 4.).

For example, since the non-volatile blocking layer 140 is formed by a reaction between a material to be etched and an etching gas or a gas radical, the amount of chemical reaction may be controlled depending upon the material to be etched and the etching gas or the gas radicals. For example, it may be SiO₂, but is not limited thereto.

More specifically, since the charge-transporting layer 120 may form the non-volatile blocking layer 140 by itself by a chemical reaction between the contained silicone (-Si-O-Si-) molecules and the dry-etching gas (e.g., Ar/O₂ or CF₄), it is possible to implement an anisotropic ultra-fine pattern based on photolithography and dry-etching.

For example, SixOy may be formed by a reaction between O* (radical) generated from O₂ gas and Si or Si-O (SiO + O* → SixOy or SiO + O* → SixOy), and SixOyFz may be formed by a reaction between F* (radical) generated from CF₄ gas and Si-O (Si-O + F* → SixOyFz).

Accordingly, the patterning method for the charge-transporting layer according to an embodiment of the present invention may simultaneously secure chemical resistance and etch resistance and implement an ultra-high-resolution pattern (2 µm or less) by a photolithography process and a dry etching method by introducing the organic silica precursor to the curable small-molecule organic semiconductor to form the silicone (-Si-O-Si-) network.

In addition, the patterning method for the charge-transporting layer according to an embodiment of the present invention not only may prevent crosstalk between pixels which may be caused in an ultra-high-resolution full-color OLED display, but also may induce an increase in the OLED device characteristics through the alignment of the energy level (HOMO level) of the charge-transporting layer, thereby realizing a charge-transporting complex silicone (-Si-O-Si-) network (SPN & IPN) that simultaneously secures high luminescence efficiency and high durability. Accordingly, excellent luminescence characteristics may be provided, and an ultra-fine pattern may be implemented by general-purpose photolithography and a dry-etching process.

That is, the patterning method for the charge-transporting layer according to an embodiment of the present invention, which is an ultra-high-resolution pattern process technology utilizing a photolithography-tailored charge-transporting complex and the non-volatile blocking layer 140, may be used to manufacture ultra-high-resolution full-color OLED microdisplay devices and may be applied as a visual-based emotional interface platform technology capable of implementing ultra-realistic and immersive virtual and augmented reality.

Finally, the patterning method for the charge-transporting layer according to an embodiment of the present invention includes a step S150 of removing the photoresist pattern 131.

In the step S150, the photoresist pattern 131 may be removed by a development process so that the charge-transporting layer pattern 121 may be formed on the substrate 110.

The size (width) of the charge-transporting layer pattern 121 may be from several hundred nanometers to several hundred micrometers. For example, the size of the charge-transporting layer pattern 121 may be from 10 nm to 1000 µm, but is not limited thereto. The size of the charge-transporting layer pattern 121 may be variously adjusted depending upon the size of an OLED display to be applied with the organic light-emitting pattern 121 and the purpose of use.

FIG. 3a illustrates a schematic diagram for comparing a wet-etching process of an existing hole-transporting layer with a dry-etching process of the patterning method for the charge-transporting layer according to an embodiment of the present invention.

In the case of an existing technology that increases durability by introducing a cross-linking functional group to a hole-transporting layer, it is impossible to apply photolithography and dry-etching for implementing ultra-high-resolution patterns because only the chemical resistance of a hole-transporting layer material to a solvent can be secured.

In addition, cases of directly applying photolithography to organic electronic materials to implement high-resolution patterns have been reported, but they are limited to polymer materials, not low-molecular organic semiconductors with high industrial applicability, and since patterns are mainly implemented through a wet-etching process, not a dry-etching process, they have limitations of low pattern density and uniformity.

Referring to FIG. 3a, in the case of a wet-etching process, there is a limitation that the pattern density and uniformity are low because it is etched isotropically. In addition, over-etching may cause an undercut phenomenon in which an etched area spreads.

In the case of a dry-etching process, the vertical etching speed is faster due to anisotropy, but as the depth of the pattern being etched increases, the side surface direction is also etched at a lower speed, which limits the implementation of anisotropic patterns. As an example to solve the above problem, there is a Bosch process that enables etching in a high aspect ratio by alternately repeating the passivation process of artificially forming a blocking layer during the dry-etching process, and the etching process. However, the process has problems such as the scalloping effect that the side surface of a pattern is formed in a sawtooth shape, and a long process time.

Accordingly, there is a problem that the pattern accuracy, pattern density and uniformity of the charge-transporting layer pattern 121 are lowered.

However, since the patterning method for the charge-transporting layer according to an embodiment of the present invention includes a charge-transporting composite in which the charge-transporting layer 120 has the silicone (-Si-O-Si-)-integrated network, a non-volatile blocking layer 140 that reacts with an etching gas when dry-etching the charge-transporting 120 to protect the charge-transporting pattern 121 on the side surface of the charge-transporting pattern 121 is formed by itself, pattern accuracy, pattern density and uniformity may be improved.

Accordingly, the patterning method for the charge-transporting layer according to an embodiment of the present invention may implement a charge-transporting complex silicone (-Si-O-Si-) network (SPN & IPN) having both high luminous efficiency and high durability, thereby implementing an ultra-fine pattern through general photolithography and dry etching while maintaining the excellent luminescence characteristics of OLED.

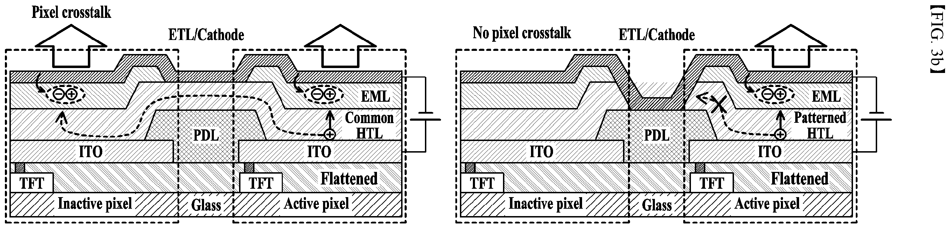

FIG. 3b illustrates schematic diagrams for comparing charge-transporting layer patterns by a patterning method of the existing hole-transporting layer and the charge-transporting layer according to an embodiment of the present invention.

In the case of an existing hole-transporting layer, crosstalk occurs with increasing pixel density (minimum 300 PPI), resulting in problems such as color purity, sharpness, and gamut area degradation.

More specifically, since the second electrode (e.g., a negative electrode) is generally a common electrode and the hole-transporting layer is connected to a plurality of pixels (e.g., the first pixel, the second pixel), a current flows through the hole-transporting layer and the organic light-emitting layer to the second electrode when the first pixel (active pixel) emits light, causing a problem in which the second pixel (inactive pixel) also emits light. In this way, crosstalk may occur when adjacent pixels emit light.

Accordingly, when the pixel density of the organic light-emitting device increases due to an ultra-fine pattern, crosstalk becomes more serious, and the luminescence characteristics of the device may deteriorate rapidly.

However, the organic light-emitting device according to an embodiment of the present invention can prevent crosstalk by preventing a current from moving to the hole-transporting layer and organic light-emitting layer of the second pixel (inactive pixel) and thus the second pixel (inactive pixel) from emitting together when the first pixel (active pixel) emits light by high-resolution patterning of the charge-transporting complex including the silicone (-Si-O-Si-) network (SPN & IPN) structure because the hole-transporting layer is patterned by the patterning method for the charge-transporting layer according to an embodiment of the present invention.

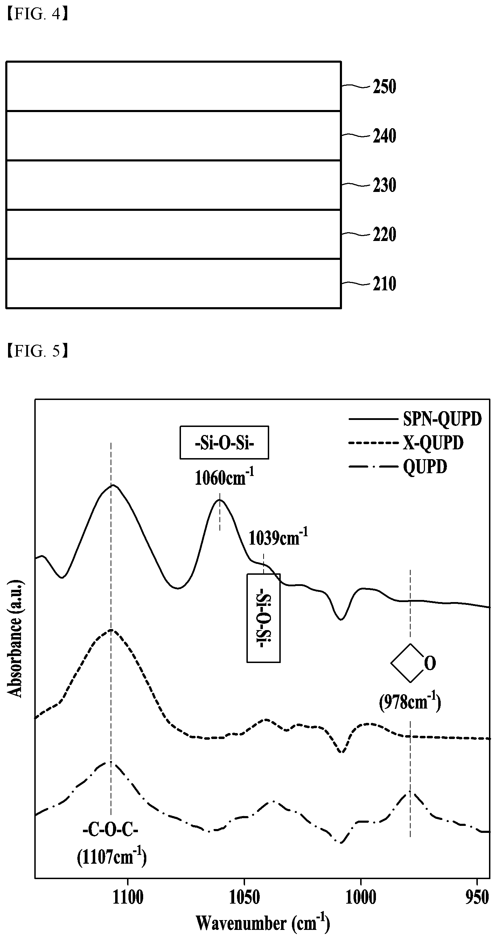

FIG. 4 illustrates the sectional view of an organic light-emitting device according to an embodiment of the present invention.

The organic light-emitting device according to an embodiment of the present invention may include a first electrode 210 formed on a substrate, an organic light-emitting layer 230 formed on the first electrode 210, a second electrode 250 formed on the organic light-emitting layer 230 and the interface between the first electrode 210 and the organic light-emitting layer 230 and at least one of charge-transporting layers 220 and 240 formed at least one of the interface between the organic light-emitting layer 230 and the second electrode 250 and including the charge-transporting complex according to an embodiment of the present invention.

Accordingly, in the organic light-emitting device according to an embodiment of the present invention, the charge-transporting complex according to an embodiment of the present invention may be included only in the hole-transporting layer 220, the charge-transporting complex according to an embodiment of the present invention may be included only in the electron-transporting layer 240, or the charge-transporting complex according to an embodiment of the present invention may be included in both the hole-transporting layer 220 and the electron-transporting layer 240.

If the charge-transporting complex according to an embodiment of the present invention of the organic light-emitting device according to an embodiment of the present invention is included only in the hole-transporting layer 220 or the electron-transporting layer 240, a hole-transporting layer 220 or electron-transporting layer 240 generally used in the art may be used as the hole-transporting layer 220 or electron-transporting layer 240 not including the charge-transporting complex according to an embodiment of the present invention.

Hereinafter, the organic light-emitting device according to an embodiment of the present invention in which the hole-transporting layer 220 includes the charge-transporting complex according to an embodiment of the present invention is described with reference to FIG. 4, but the organic light-emitting device according to an embodiment of the present invention is not limited thereto and may have the same configuration and effects even if the electron-transporting layer 240 includes the charge-transporting complex according to an embodiment of the present invention.

The organic light-emitting device has a principle in which electrons and holes injected through a cathode and anode are recombined in the organic light-emitting layer 230, and when the exciton generated at this time falls to the ground state, visible light corresponding to the energy gap of the organic light-emitting layer 230 material is emitted. Depending upon how the organic light-emitting layer 230 is formed, a blue, green, or red light-emitting device may be implemented.

The organic light-emitting device according to an embodiment of the present invention includes a first electrode 210 formed on a substrate, a hole-transporting layer 220 formed on the first electrode 210 and configured to include the charge-transporting complex according to an embodiment of the present invention, an organic light-emitting layer 230 formed on the hole-transporting layer 220, an electron-transporting layer 240 formed on the organic light-emitting layer 230 and a second electrode 250 formed on the electron-transporting layer 240.

Accordingly, since the organic light-emitting device according to an embodiment of the present invention includes the hole-transporting layer 220 including the charge-transporting complex according to an embodiment of the present invention, chemical resistance to a solvent and resistance to a dry etching gas may be secured simultaneously, so that photolithography and a dry etching method may be directly applied to the material of the hole-transporting layer 220, thereby capable of implementing ultra-fine patterns of several micrometers.

Furthermore, since the organic light-emitting device according to an embodiment of the present invention includes the hole-transporting layer 220 including the charge-transporting complex according to an embodiment of the present invention, the ultra-high-resolution pattern of the hole-transporting layer 220 may be implemented, and the charge transfer efficiency may be improved due to a reduction in the difference in energy levels (HOMO levels) between the organic light-emitting layer 230 (organic light-emitting body) and the hole-transporting layer 220 (charge-transporting complex), thereby effectively improving the EQE and luminous efficiency of OLED devices for solution processes.

First, the organic light-emitting device according to an embodiment of the present invention includes the first electrode 210 formed on the substrate.

According to an embodiment, the first electrode 210 may be formed on a substrate, or the first electrode 210 may function as both an electrode and a substrate.

As a substrate, substrates used in general organic light-emitting devices may be used, but it is preferable to use a glass substrate or transparent plastic substrate that has excellent transparency, surface smoothness, ease of handling, and waterproofing.

The first electrode 210 may be patterned in pixel units to inject holes into the organic light-emitting layer 230. For example, the first electrode 210 may be an anode.

The first electrode 210 may be connected to one of source and drain electrodes of a thin film transistor and may serve to receive a driving current applied from the thin film transistor.

The first electrode 210 may be formed of known electrode materials used in organic light-emitting devices. Preferably, the first electrode 210 may include at least one of gold (Au), palladium (Pd), platinum (Pt), indium tin oxide (ITO), aluminum zinc oxide (AZO), fluorine tin oxide (FTO), indium zinc oxide (IZO), zinc oxide (ZnO), carbon nanotubes (CNT), graphene, polyethylenedioxythiophene:polystyrenesulfonate (PEDOT:PSS) and silver nanowires (AgNWs).

More preferably, the first electrode 210 may include indium tin oxide (ITO) which is a transparent electrode with a large work function to facilitate the injection of holes into the highest occupied molecular orbital (HOMO) level of the organic light-emitting layer 230.

The organic light-emitting device according to an embodiment of the present invention includes the hole-transporting layer 220 including the charge-transporting complex according to an embodiment of the present invention.

The hole-transporting layer 220 may include the charge-transporting complex according to an embodiment of the present invention, and may be a charge-transporting layer pattern patterned by the patterning method for the charge-transporting layer according to an embodiment of the present invention.

Accordingly, since the hole-transporting layer 220 includes the same components as in the charge-transporting complex according to an embodiment of the present invention and the patterning method for the charge-transporting layer according to an embodiment of the present invention, descriptions of the same components are omitted.

The charge-transporting layer may include at least two sub-charge transport layers whose organic silica precursor concentrations are different.

The at least two sub-charge transport layers having different concentrations may have a concentration gradient such that the concentration of the organic silica precursor in the electrode (the first electrode 210) increases toward the organic light-emitting layer 230.

For example, when the charge-transporting complex according to an embodiment of the present invention is included in the hole-transporting layer 220, the first sub-charge transport layer and the second sub-charge transport layer may be included between the first electrode 210 and the organic light-emitting layer 230 in the hole-transporting layer 220, and the concentration of the organic silica precursor in the second sub-charge transport layer may be higher than that of the first sub-charge transport layer. Here, the first sub-charge transport layer is a charge-transporting layer facing the first electrode 210, and the second sub-charge transport layer is a charge-transporting layer facing the organic light-emitting layer 230.

When the hole-transporting layer 220 is formed as a multilayer, the energy level (HOMO level) of the hole-transporting layer 220 and the energy level (HOMO level) of the organic light-emitting layer 230 may be aligned to increase the charge injection efficiency.

That is, since the energy level (HOMO level) of the charge-transporting complex moves toward a deep level as the content of the organic silica precursor increases, the alignment of the energy level (HOMO level) may be improved by adjusting the content of the organic silica precursor included in the first sub-charge transport layer and the second sub-charge transport layer (the content of the organic silica precursor of the first sub-charge transport layer < the content of the organic silica precursor of the second sub-charge transport layer). Accordingly, the concentration of the organic silica precursor included in the first sub-charge transport layer and the second sub-charge transport layer is not particularly limited, but the concentration of the organic silica precursor in the second sub-charge transport layer should be higher than that in the first sub-charge transport layer.

According to an embodiment, the hole-transporting layer 220 may include at least one of a hole-injecting layer and an electron-blocking layer.

The hole-injecting layer is a layer that facilitates the injection of holes from the anode of the first electrode 210 to the organic light-emitting layer 230, and has a single layer or a multilayer structure of two or more layers. The hole injection material is a material that can easily receive holes from the first electrode 210 at a low voltage, and the Highest Occupied Molecular Orbital (HOMO) of the hole injection material is preferably between the work function of the material of the first electrode 210 and the HOMO of the surrounding organic layer.

Examples of the hole injection material include, but are not limited to, metal porphyrine, oligothiophene, arylamine-based organic matter, hexanitrilehexaazatriphenylene-based organic matter, quinacridone-based organic matter, perylene-based organic matter, anthraquinone, and polyaniline- and polycompound-based conductive polymers, etc.

A hole transport layer may play a role in facilitating the transport of holes, and has a single-layer or multilayer structure of two or more layers. As the hole transport material, a material that can receive holes from the first electrode 210 or the hole-injecting layer and transfer them to the organic light-emitting layer 230 and has high mobility for holes is suitable.

The organic light-emitting device according to an embodiment of the present invention includes the organic light-emitting layer 230 formed on the hole-transporting layer 220.

The organic light-emitting layer 230 is a layer in which holes that have been injected from the first electrode 210 and passed through the hole-transporting layer 220 and electrons that have been injected from the second electrode 250 and passed through an electron-transporting layer 240 recombine to generate an exciton, and the generated exciton changes from an excited state to a ground state, thereby emitting light. The layer can be composed of a single layer or multiple layers.

The organic light-emitting layer 230 may include at least one of a green-emitting layer, a red-emitting layer, a blue-emitting layer and a white-emitting layer.

According to an embodiment, the organic light-emitting layer 230 may emit phosphorescence by triplet exciton, and phosphorescence emission from the organic light-emitting layer 230 may have very high quantum efficiency compared to fluorescence emission, so a phosphorescent organic light-emitting device may increase the efficiency of an organic electroluminescent device.

In addition, the organic light-emitting layer 230 may improve the internal quantum efficiency of an organic light-emitting device by using a phosphorescent material that emits phosphorescence by triplet excitons, thereby increasing the efficiency of an organic light-emitting device.

A material forming the organic light-emitting layer 230 is not particularly limited. More specifically, the organic light-emitting layer 230 may include at least one of a blue substance including at least one of oxadiazole dimer dyes (bis-DAPOXP), spiro compounds (Spiro-DPVBi, Spiro-6P), triarylamine compounds, bis(styryl)amine (DPVBi, DSA), 4,4'-bis(9-ethyl-3-carbazovinylene)-1,1'-biphenyl (BCzVBi), perylene, 2,5,8,11-tetra-tert-butylperylene (TPBe), 9H-carbazole-3,3'-(1,4-phenylene-di-2,1-ethene-diyl)bis[9-ethyl-(9C)] (BCzVB), 4,4-bis[4-(di-p-tolylamino)styryl]biphenyl (DPAVBi), 4-(di-p-tolylamino)-4'-[(dip-tolylamino)styryl]stilbene (DPAVB), 4,4'-bis[4-(diphenylamino)styryl]biphenyl (BDAVBi) and bis(3,5-difluoro-2-(2-pyridyl)phenyl-(2-carboxypyridyl)iridium III (FIrPic), a green substance including at least one of 3-(2-benzothiazolyl)-7-(diethylamino)coumarin (Coumarin 6) 2,3,6,7-tetrahydro-1,1,7,7,-tetramethyl-1H,5H,11H-10-(2-benzothiazolyl)quinolizino-[9,9a,1gh]coumarin (C545T), N,N'-dimethyl-quinacridone (DMQA) and tris(2-phenylpyridine)iridium (III) (Ir(ppy)3) and a red substance including at least one of naphthacene (rubrene), tris(1-phenylisoquinoline)iridium (III) (Ir(piq)3), bis(2-benzo[b]thiophen-2-yl-pyridine) (acetylacetonate)iridium (III) (Ir(btp)2(acac)), tris(dibenzoylmethane)phenanthroline europium (III) (Eu(dbm)3(phen)), tris[4,4'-di-tert-butyl-(2,2')-bipyridine]ruthenium (III) complex (Ru(dtb-bpy)3*2(PF6)), DCM1, DCM2, Eu (thenoyltrifluoroacetone)3 (Eu(TTA)3 and butyl-6-(1,1,7,7-tetramethyljulolidyl-9-enyl)-4H-pyran (DCJTB).

In addition, the organic light-emitting layer 230 may include, but is not limited to, a polymer such as a phenylene-based polymer, a phenylene vinylene-based polymer, a thiophene-based polymer, a fluorene-based polymer, and a spiro-fluorene-based polymer, and an aromatic compound containing nitrogen.

In addition, the organic light-emitting layer 230 may further include a light-emitting dopant in its light-emitting layer host.

The materials of a fluorescent host may include at least one of tris(8-hydroxy-quinolinato)aluminum (Alq3), 9,10-di(naphthy-2-yl)anthracene (AND), 3-tert-butyl-9,10-di(naphthy-2-yl)anthracene (TBADN), 4,4'-bis(2,2-diphenyl-ethene-1-yl)-4,4'-dimethylphenyl (DPVBi), tert(9,9-diarylfluorene)s (TDAF), 2-(9,9'-spirobifluoren-2-yl)-9,9'-spirobifluoren (BSDF), 2,7-bis(9,9'-spirobifluoren-2-yl)-9,9'-spirobifluoren (TSDF), bis(9,9-diarylfluorene)s (BDAF) and 4,4'-bis(2,2-diphenyl-ethene-1-yl)-4,4'-di-(tert-butyl)phenyl (p-TDPVBi), and the materials of a phosphorescent host may include at least one of 1,3-bis(carbazole-9-yl)benzene (mCP), 1,3,5-tris(carbazole-9-yl)benzene (tCP), 4,4',4"-tris(carbazole-9-yl)triphenylamine (TCTA), 4,4'-bis(carbazole-9-yl)biphenyl (CBP), 4,4'-bis(9-carbazolyl)-2,2'-dimethyl-biphenyl (CBDP), 4,4'-bis(carbazole-9-yl)-9,9-dimethyl-fluorene (DMFL-CBP), 4,4'-bis(carbazole-9-yl)-9,9-bis(9-phenyl-9H-carbazole)fluorene (FL-4CBP), 4,4'-bis(carbazole-9-yl)-9,9-di-tolyl-fluorene (DPFL-CBP) and 9,9-bis(9-phenyl-9H-carbazole)fluorene (FL-2CBP).

The dopant may include at least one of a fluorescent dopant and a phosphorescent dopant.

For example, the phosphorescent dopant may include an organometallic compound including one of iridium (Ir), platinum (Pt), osmium (Os), titanium (Ti), zirconium (Zr), hafnium (Hf), europium (Eu), terbium (Tb), tholium (Tm), rhodium (Rh), and copper (Cu). The fluorescent dopant may include at least one of DPAVBi, BDAVBi, TBPe, DCM, DCJTB, Coumarin 6 and C545T below.

The organic light-emitting device according to an embodiment of the present invention includes an electron-transporting layer 240 formed on the organic light-emitting layer 230.

The electron-transporting layer 240 is a layer that transports electrons to the organic light-emitting layer 230. As an electron transport material, a material that can be well injected with electrons from the second electrode 250 and can transfer them to the organic light-emitting layer 230 is suitable. A material with high mobility for electrons is suitable.

If the electron-transporting layer 240 includes the charge-transporting complex according to an embodiment of the present invention, the electron-transporting layer 240 may include the same components as in the charge-transporting complex according to an embodiment of the present invention.

In addition, the electron-transporting layer 240 may include at least two sub-charge transport layers having different concentrations, and the at least two sub-charge transport layers having different concentrations may have a concentration gradient such that the concentration of the organic silica precursor increases from the electrode (the second electrode 250) toward the organic light-emitting layer 230.

For example, when the charge-transporting complex according to an embodiment of the present invention is included in the electron-transporting layer 240, a third sub-charge transport layer and a fourth sub-charge transport layer may be included between the second electrode 250 and organic light-emitting layer 230 of the electron-transporting layer 240, and the concentration of the organic silica precursor of the fourth sub-charge transport layer may be higher than that of the third sub-charge transport layer.

Here, the third sub-charge transport layer is a charge-transporting layer in contact with the second electrode 250, and the fourth sub-charge transport layer is a charge-transporting layer in contact with the organic light-emitting layer 230.

When the electron-transporting layer 240 does not include the charge-transporting complex according to an embodiment of the present invention, the electron-transporting layer 240 may include, for example, at least one of TPBi(2,2',2"-(1,3,5-benzinetriyl)-tris(1-phenyl-1-H-benzimidazole)), Alq₃(tris(8-hydroxyquinoline) Aluminum), PCBM(phenyl-C61-butyric acid methyl ester), TAZ(3-(4-biphenyl)-4-phenyl-5-(4-tertbutylphenyl)-1,2,4-triazole), BPhen(4,7-diphenyl-1,10-phenanthroline), BAlq(bis(8-hydroxy-2-methylquinoline)-(4-phenylphenoxy)aluminum), TSPO1 (diphenylphosphine oxide-4-(triphenylsilyl)phenyl), B₄PyMPM [bis-4,6-(3,5-di-4-pyridylphenyl)-2-methylpyrimidine], TmPyPB (two pyridine-containing triphenylbenzene derivatives of 1,3,5-tri(m-pyrid- 3-yl-phenyl)benzene), 3TPYMB (tris-[3-(3-pyridyl)mesityl] borane), TpPyPB (1,3,5-tri(p -pyrid-3-yl-phenyl)benzene), TPPB (1,3,5-tris[3,5-bis(3-pyridinyl)phenyl]benzene) and BCP(2,9-dimethyl-4,7-diphenyl-1,10-phenanthroline).

According to an embodiment, the electron-transporting layer 240 may include at least one of an electron-injecting layer and a hole-blocking layer.

The electron-injecting layer, which is a layer that injects electrons from the second electrode 250, is made of preferably a compound having the ability to transport electrons, having an excellent electron injection effect from the second electrode 250 and an excellent electron injection effect to the organic light-emitting layer 230, capable of preventing the movement of excitons generated in the organic light-emitting layer 230 to a hole-injecting layer, and having an excellent thin film forming ability. For example, the electron-injecting layer may be made of fluorenone, anthraquinodimethane, diphenoquinone, thiopyran dioxide, oxazole, oxadiazole, triazole, imidazole, perylenetetracarboxylic acid, preorenylidene methane, anthrone or its derivative, a metal complex compound, a nitrogen-containing 5-membered ring derivative, etc., without being limited thereto.

The hole-blocking layer, which is a layer that blocks holes from reaching the second electrode 250, may generally be formed under the same conditions as the hole injection layer. For example, the hole-blocking layer may be made of, but is not limited to, an oxadiazole derivative, a triazole derivative, a phenanthroline derivative, BCP, an aluminum complex, etc.

The organic light-emitting device according to an embodiment of the present invention includes the second electrode 250 that is formed on the electron-transporting layer 240 formed on the substrate.

For example, the second electrode 250 may be a negative electrode (cathode). The second electrode 250 may be commonly connected to power supply voltage and may serve to inject electrons into the organic light-emitting layer 230.

The second electrode 250 may be formed of known electrode materials used in organic light-emitting devices, Preferably, the second electrode 250 may include at least one of lithium fluoride/aluminum (LiF/Al), aluminum (Al), silver (Ag), gold (Au), copper (Cu), palladium (Pd), platinum (Pt), magnesium (Mg), magnesium silver (Mg:Ag), ytterbium (Yb), and calcium (Ca).

More preferably, as the second electrode 250, a metal electrode having a low work function for easy injection of electrons into the lowest unoccupied molecular orbital (LUMO) level of the organic light-emitting layer 230 and excellent internal reflectivity may be used. The second electrode 250 may include at least one of lithium fluoride/aluminum (LiF/Al), aluminum (Al), silver (Ag), copper (Cu), palladium (Pd), magnesium (Mg), magnesium silver (Mg:Ag) and ytterbium (Yb).

The first electrode 210 and the second electrode 250 are electrically separated from each other and provide power to an organic light-emitting device. In addition, the first electrode 210 and the second electrode 250 may reflect light generated from the organic light-emitting device to increase light efficiency, and may also serve to discharge heat generated from the organic light-emitting device to the outside.

### Example 1: SPN + QUPD

In a 4 ml vial, a curable organic semiconductor (QUPD) was dissolved in a chlorobenzene solvent and stirred for 6 hours under a nitrogen environment to prepare a solution. 3-ethyl-3-[[3-(triethoxysilyl)propoxy]methyl]oxetane (organic silica precursor) was added to the prepared solution in an amount of 1.40% by weight to 6.07% by weight (4 mol% to 16 mol%) relative to the curable organic semiconductor, followed by stirring for 1 hour under a nitrogen environment. The stirred solution was completely applied onto a substrate coated with PEDOT:PSS (AI4083), and then a hole transport layer thin film was formed by spin coating (2,000 rpm, 60 sec).

The formed thin film was heat-treated at 180 °C for 3 hours in a nitrogen environment to perform an oxetane group crosslinking reaction and a silicone network forming reaction between the curable organic semiconductor and an organic silica precursor, thereby finally producing a hole transport layer composition where silicone (-Si-O-Si-) was bonded.

### Comparative example: QUPD

A solution was prepared by dissolving a curable organic semiconductor (QUPD) in a chlorobenzene solvent in a 4 ml vial and stirring for 6 hours under a nitrogen environment. The prepared solution was completely applied on a substrate coated with PEDOT:PSS (AI4083), and then a thin hole transport layer film was formed by spin coating (2,000 rpm, 60 sec).

### Example 2-1: 4 mol% SPN + QUPD

After PEDOT:PSS (Al4083) was applied to the entire surface of an ITO (anode) substrate, a thin film was formed by spin coating (4,000 rpm, 60 sec), and then heat treated at 120 °C for 1 hour to form a charge injection layer.

A solution was prepared by dissolving a curable organic semiconductor (QUPD) in a chlorobenzene solvent in a 4 ml vial and stirring for 6 hours in a nitrogen environment. 3-ethyl-3-[[3-(triethoxysilyl)propoxy]methyl]oxetane (organic silica precursor) was added to the prepared solution at 4 mol% relative to the curable organic semiconductor, and stirred for 1 hour in a nitrogen environment. After the stirred solution was completely applied onto a substrate coated with PEDOT:PSS (AI4083), a thin hole transport layer film was formed by spin coating (2,000 rpm, 60 sec).

The formed thin film was heat-treated at 180°C for 3 hours in a nitrogen environment to perform an oxetane group crosslinking reaction and a silicon network formation reaction between the curable organic semiconductor and the organic silica precursor, thereby finally producing a hole-transporting layer where silicon (-Si-O-Si-) was bonded.

A solution containing a mixture of host (CBP) and dopant (Ir(ppy)₃) was applied to the entire surface of the formed hole-transporting layer, and a thin film was formed by spin coating (2,000 rpm, 60 sec), followed by heat treatment at 180°C for 30 minutes, thereby forming an organic light-emitting layer. TPBi(2,2',2"-(1,3,5-benzinetriyl)-tris(1-phenyl-1-H-benzimidazole), which was an electron transport layer, and LiF:Al/Al, which was a cathode electrode, were deposited on the formed organic light-emitting layer to finally manufacture an organic light-emitting diode device.

### Example 2-2: 8 mol% SPN + QUPD

An organic light-emitting diode device was manufactured in the same manner as in Example 2-1 except that the organic silica precursor was contained at 8 mol% in Example 2-1.

### Example 2-3: 16 mol% SPN + QUPD

An organic light-emitting diode device was manufactured in the same manner as in Example 2-1 except that the organic silica precursor was contained at 16 mol% in Example 2-1.

### Example 3: Bilayer

After PEDOT:PSS (Al4083) was applied to the entire surface of an ITO (anode) substrate, a thin film was formed by spin coating (4,000 rpm, 60 sec), and then heat treated at 120 °C for 1 hour to form a charge injection layer. A solution (4 mol% to 1.4% by weight of an organic silica precursor relative to the host weight) containing a cross-linked small-molecule semiconductor material (QUPD[N4,N4'-bis(4-(6-((3-ethyloxetan-3-yl)methoxy)hexyloxy)phenyl)-N4,N4'-bis(4-methoxyphenyl)biphenyl-4,4'-diamine]) and an organic silica precursor (QUPD-oxetane precursor) was spin-coated in a nitrogen environment (2,000 rpm, 60 sec) to form a thin film, and then heat-treated at 180°C for 3 hours to form a cross-linked first charge transport layer. A solution (16 mol% to 6% by weight relative to the host weight) containing QUPD and the organic silica precursor (QUPD-oxetane precursor) was spin-coated on the formed first charge transport layer in a nitrogen environment (2,000 rpm, 60 sec) to form a thin film, and then heat-treated at 180°C for 3 hours to form a cross-linked second charge transport layer. A host (CBP)-dopant (Ir(ppy)₃) solution (host: 95 wt%, dopant: 5 wt%) was applied to the entire surface of the formed second charge transport layer, and an organic light-emitting layer thin film was formed by spin coating (2,000 rpm, 60 sec). TPBi(2,2',2"-(1,3,5-benzinetriyl)-tris(1-phenyl-1-H-benzimidazole), which was an electron transport layer, and LiF:Al/Al, which was a cathode electrode, were deposited on the formed organic light-emitting layer to finally manufacture an organic light-emitting diode device.

FIG. 5 illustrates the results of Fourier-transform infrared spectroscopy (FT-IR) analysis for the crosslinking reaction of the charge-transporting complex according to Example 1.

Referring to FIG. 5, it can be seen that, in the charge-transporting complex according to Example 1, a silicon network structure is formed by the CROP reaction of oxetane and the silicon condensation reaction by introducing a silicone-oxetane organic silica precursor into a curable small-molecule organic semiconductor (QUPD) material (oxetane (978 cm⁻¹) ↓ and ether (1107 cm⁻¹)↑).

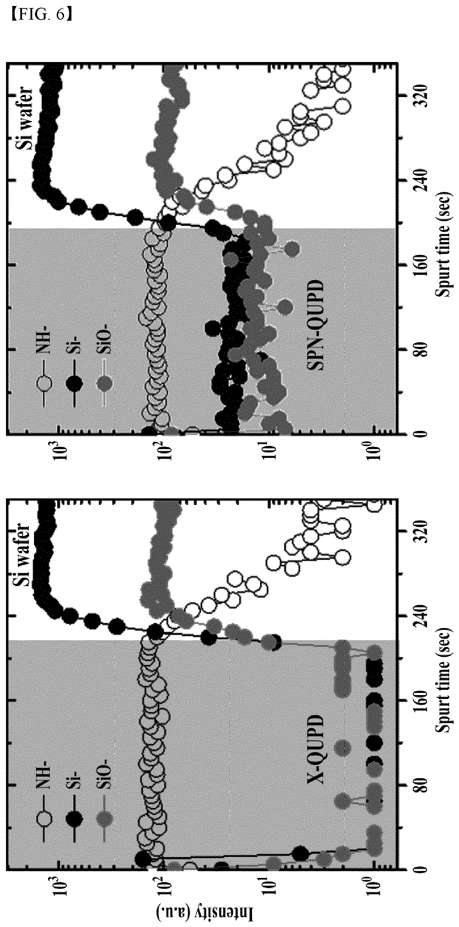

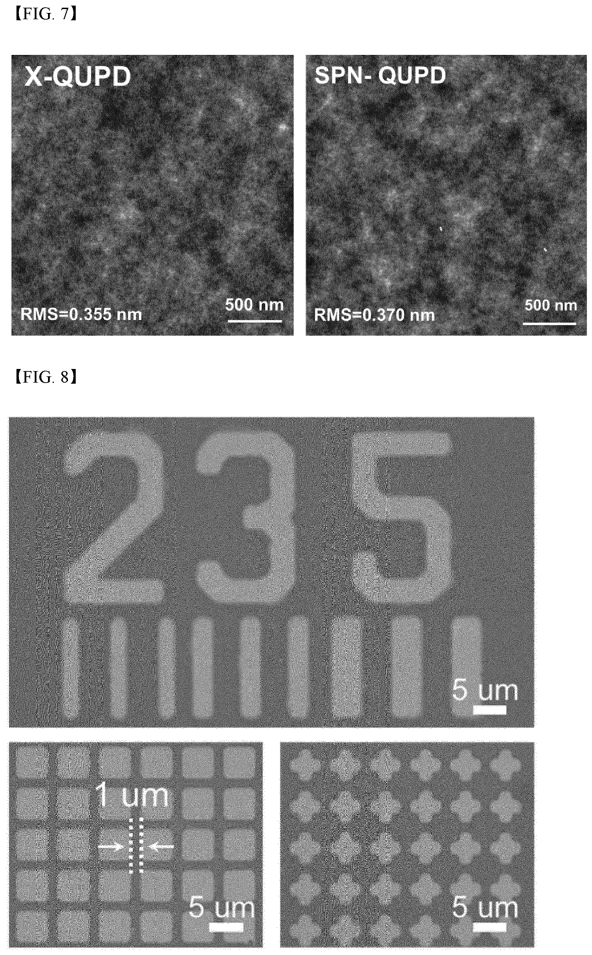

FIG. 6 illustrates the results of Time-of-Flight Secondary Ion Mass Spectrometry (ToF-SIMS) analysis for the hole-transporting layer including QUPD (X-QUPD) and the charge-transporting complex (SPN-QUPD) according to Example 1, and FIG. 7 illustrates an Atomic Force Microscope (AFM) measurement image of the hole-transporting layer including QUPD (X-QUPD) and the charge-transporting complex (SPN-QUPD) according to Example 1.

Referring to FIGS. 6 and 7, it can be seen that, in the hole-transporting layer including the charge-transporting complex (SPN-QUPD) according to Example 1, a silicon network is uniformly formed within the QUPD thin film without micro-phase separation.

FIG. 8 illustrates the charge-transporting layer pattern of a hole-transporting layer including the charge-transporting complex (SPN-QUPD) according to Example 1.

Referring to FIG. 8, it can be seen that a hole-transporting layer including the charge-transporting complex (SPN-QUPD) according to Example 1 can implement ultra-fine patterns of about 2 µm in size through photolithography and a dry-etching process.

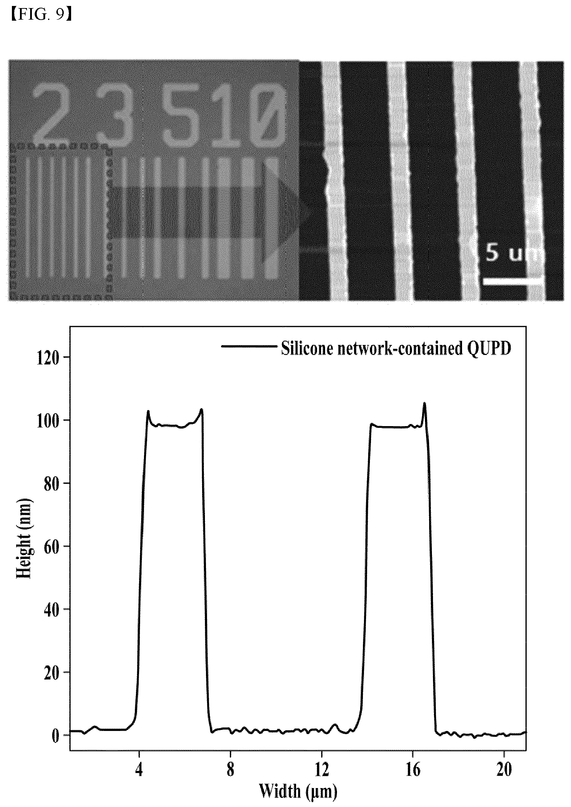

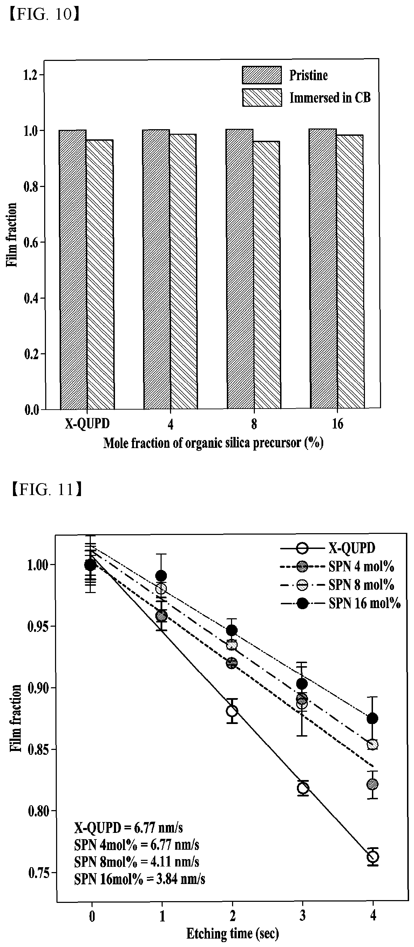

FIG. 9 illustrates the widths and heights of high-resolution patterns of a hole-transporting layer including the charge-transporting complex (SPN-QUPD) according to Example 1, FIG. 10 illustrates chemical resistance test results, and FIG. 11 illustrates etch resistance test results.

Referring to FIGS. 9 to 11, it can be seen that the hole-transporting layer including the charge-transporting complex (SPN-QUPD) according to Example 1 can simultaneously secure chemical resistance and etch resistance (about 20% or more was reduced) due to the silicone network-containing QUPD material..

In particular, it can be seen that a hole-transporting layer including the charge-transporting complex (SPN-QUPD) according to Example 1, in which 4 mol% of the organic silica precursor was included in the charge-transporting complex, has a high dry-etching process resistance of SI-HTL, and an ultra-fine pattern of 2 µm (specifically about 1 µm) can be implemented by a photolithography process and a dry etching method.

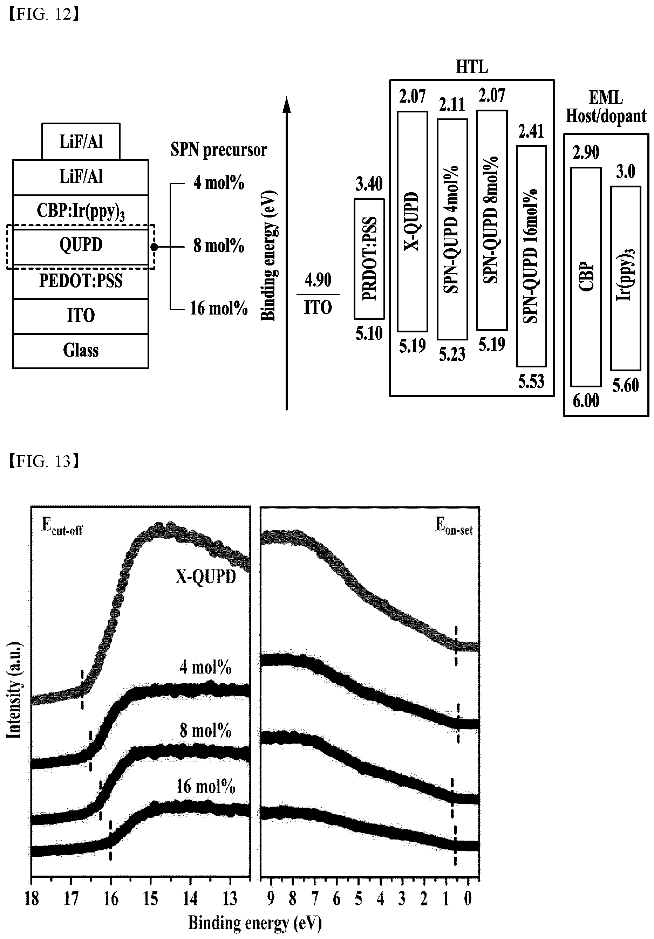

FIG. 12 illustrates the schematic diagrams and energy band diagrams of the organic light-emitting devices (Examples 2-1, 2-2 and 2-3) in which the charge-transporting complexes (SPN 4 mol%, 8 mol%, 16 mol%) according to Example 1 with different organic silica precursor concentrations are included in the hole-transporting layers.

Referring to FIG. 12, the organic light-emitting device according to the comparative example has the ITO/PEFOT:PSS/QUPD/CBP:Ir(ppy)₃/TPBi/LiF/Al structure, the organic light-emitting device according to Example 2-1 has the ITO/PEFOT:PSS/SPN-QUPD 4 mol%/CBP:Ir(ppy)₃/TPBi/LiF/Al structure, the organic light-emitting device according to Example 2-2 has the ITO/PEFOT:PSS/SPN-QUPD 8 mol%/CBP:Ir(ppy)₃/TPBi/LiF/Al structure, and the organic light-emitting device according to Example 2-3 has the ITO/PEFOT:PSS/SPN-QUPD 16 mol%/CBP:Ir(ppy)₃/TPBi/LiF/Al structure.

In addition, in the case of the hole-transporting layer, the optoelectronic characteristics and the energy level structure are very important for the high performance of OLEDs, and it can be seen that the organic light-emitting devices according to Examples 2-1 to 2-3 maintain UV characteristics and band gaps despite the silicon network being contained in their hole-transporting layers.

Further, it can be seen that the organic light-emitting devices according to Examples 2-1 to 2-3 have the HOMO level of SI-HTL moving to a deep level due to the electron-withdrawing effect of silicon (-Si-O-) as the content of the organic silica precursor increases.

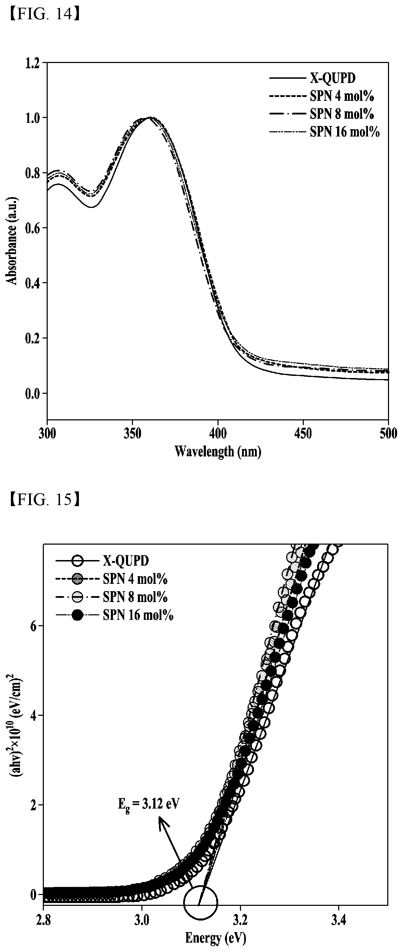

FIG. 13 illustrates ultraviolet photoelectron spectroscopy (UPS) spectra, FIG. 14 illustrates absorbances, and FIG. 15 illustrates band gaps (energy gaps) through a Tauc plot.

Referring to FIGS. 13 to 15, it can be seen that, as the content of the organic silica precursor in the hole-transporting layer included in each of the organic light-emitting devices according to Examples 2-1 to 2-3 increases, the energy level (HOMO level) alignment of the organic light-emitting layer with a small-molecule organic light-emitting body (Green) is improved.

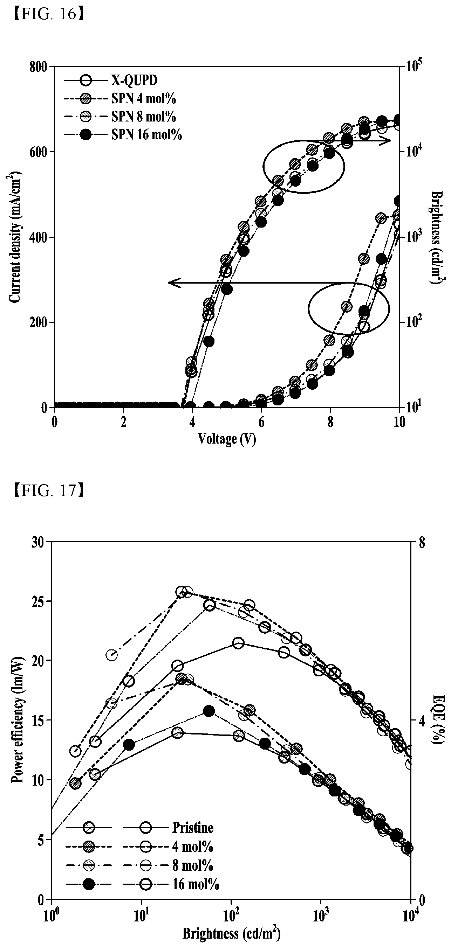

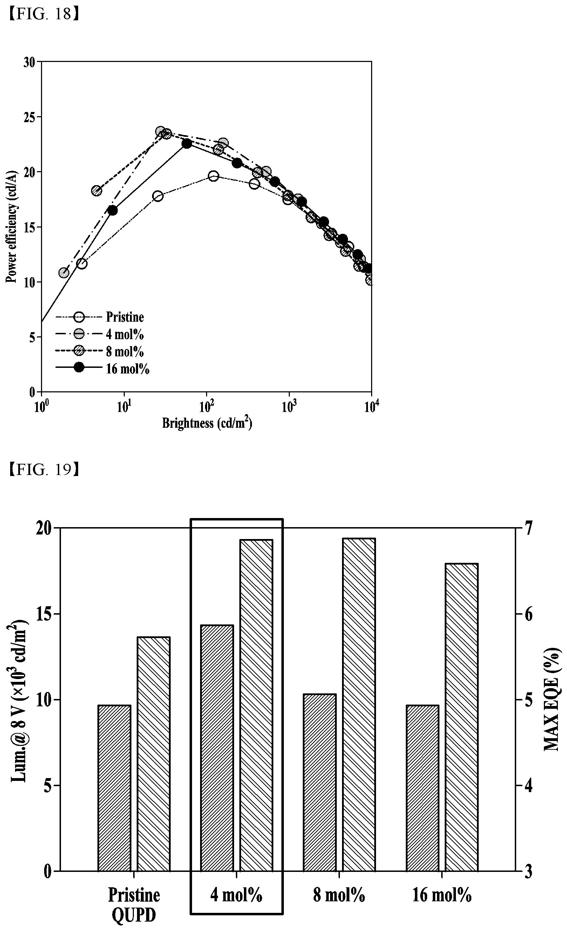

FIG. 16 illustrates the voltage-dependent current density and brightness of each of the organic light-emitting device according to the comparative example and the organic light-emitting devices according to Examples 2-1 to 2-3, FIG. 17 illustrates brightness-dependent power efficiency and external quantum efficiency, FIG. 18 illustrates brightness-dependent power efficiency, and FIG. 19 illustrates the brightness and maximum quantum efficiency dependent upon the content of the organic silica precursor.

Examining the luminescence characteristics of silicone network-containing QUPD-based OLED devices which are dependent upon the content of the organic silica precursor included in the charge-transporting complex according to an embodiment of the present invention shown in FIGS. 16 to 19, it can be seen that the hole-transporting layers included in the organic light-emitting devices according to Examples 2-1 to 2-3 exhibit improved luminescence performance compared to the organic light-emitting device according to the comparative example and, in particular, the organic light-emitting device according to Example 2-1 exhibits the most excellent luminescence performance.

More specifically, it can be seen that the organic light-emitting device (4 mol% of silicone network-containing QUPD has been introduced) according to Example 2-1 can secure improved luminescence characteristics such as a brightness of 14,320 cd/m² (1.5 times higher than the crosslinked QUPD of the comparative example @ 8V) and an EQE of 6.9% (about 1.2 times higher than the crosslinked QUPD of the comparative example) in OLED unit devices.

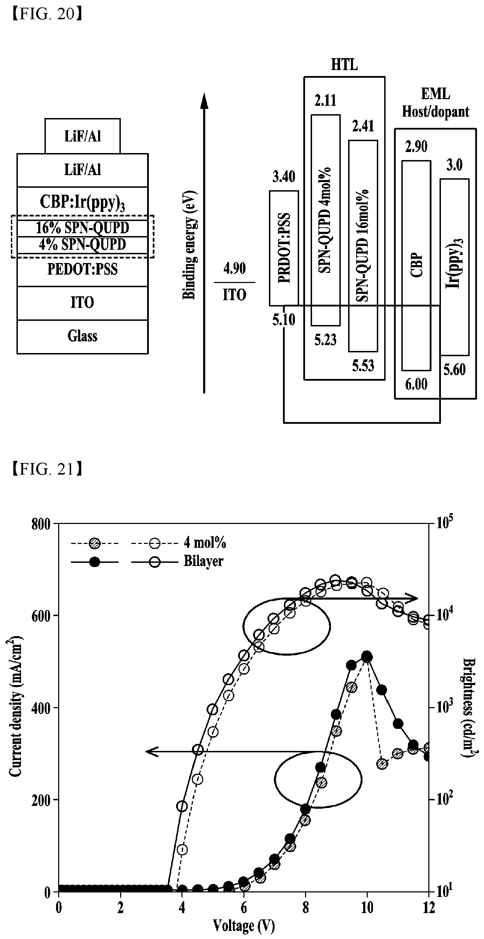

FIG. 20 illustrates the schematic diagram and energy band diagram of the organic light-emitting device according to Example 3.

Referring to FIG. 20, the organic light-emitting device according to Example 3 has the ITO/PEFOT:PSS/SPN-QUPD 4 mol%/SPN-QUPD 16 mol%/CBP:Ir(ppy)₃/TPBi/LiF/Al structure.

In addition, in the case of the hole-transporting layer, the optoelectronic characteristics and energy level structure are very important for the high performance of OLED, and it can be seen that the organic light-emitting device according to Example 3 has a HOMO level that is well aligned with the organic light-emitting layer (CBP) by using a bilayer, composed of organic silica precursors having different concentrations, as a hole-transporting layer.

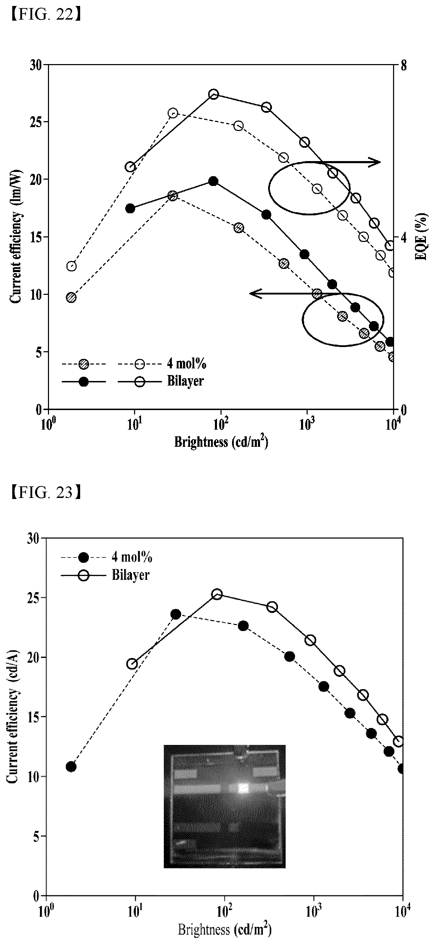

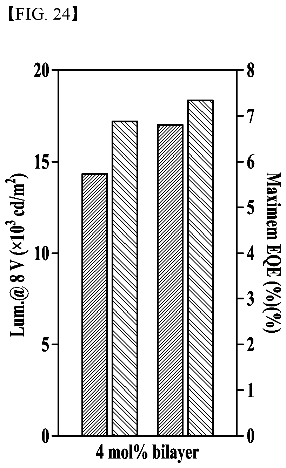

FIG. 21 illustrates the voltage-dependent current density and brightness of each of the organic light-emitting device according to Example 2-1 and the organic light-emitting device according to Example 3, FIG. 22 illustrates graphs for comparing brightness-dependent power efficiency and external quantum efficiency, FIG. 23 illustrates graphs for comparing brightness-dependent power efficiency, and FIG. 24 illustrates graphs for comparing brightness and maximum quantum efficiency.

Referring to FIGS. 21 to 24, it can be seen that the organic light-emitting device according to Example 3 uses a bilayer, composed of organic silica precursors having different concentrations, as a hole-transporting layer, so that it has a HOMO level that is well aligned with the organic light-emitting layer (CBP), thereby having improved luminescence performance compared to the organic light-emitting device according to Example 2-1.

Meanwhile, embodiments of the present invention disclosed in the present specification and drawings are only provided to aid in understanding of the present invention and the present invention is not limited to the embodiments. It will be apparent to those skilled in the art that various modifications can be made to the above-described exemplary embodiments of the present invention without departing from the spirit and scope of the invention.

## Claims

1. A charge-transporting complex, comprising:
a curable organic semiconductor; and
an organic silica precursor,
wherein the organic silica precursor and the curable organic semiconductor form a silicone (-Si-O-Si-) network structure together,
wherein the curable organic semiconductor comprises a cross-linking functional group.

2. The charge-transporting complex according to claim 1, wherein the cross-linking functional group comprises at least one of a vinyl group, a vinyl derivative, an oxetane group, a boronic acid group, trifluoro vinyl ether, benzocyclobutene and epoxide.

3. The charge-transporting complex according to claim 2, wherein the cross-linking functional group comprises a functional group represented by one of Formulas 3 to 8 below: 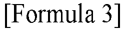 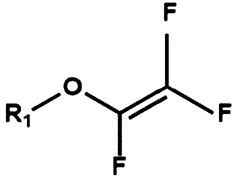 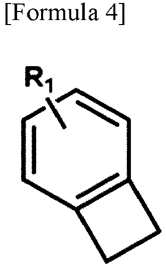 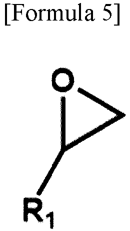 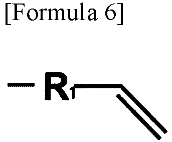 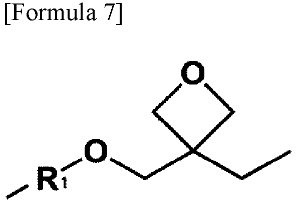 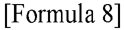 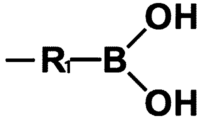 in Formulas 3 to 8, R₁ each independently comprises one of a hydrogen, a heavy hydrogen, a cyano group, a halogen group, an amino group, a thiol group, a hydroxy group, a nitro group, a carbonyl group, an ether group, a silane group, a siloxane group, a substituted or unsubstituted alkyl group having 1 to 20 carbon atoms, a substituted or unsubstituted cycloalkyl group having 3 to 20 carbon atoms, a substituted or unsubstituted alkenyl group having 2 to 20 carbon atoms, a substituted or unsubstituted alkynyl group having 2 to 20 carbon atoms, a halogenated alkyl group having 1 to 20 carbon atoms, a substituted or unsubstituted fluorenyl group, a substituted or unsubstituted aryl group having 6 to 30 carbon atoms, a substituted or unsubstituted aryloxy group having 6 to 30 carbon atoms, a substituted or unsubstituted alkoxy group having 1 to 20 carbon atoms, a substituted or unsubstituted alkylsilyl group having 1 to 20 carbon atoms, a substituted or unsubstituted arylsilyl group having 6 to 30 carbon atoms, a substituted or unsubstituted arylalkyl group having 7 to 30 carbon atoms, a substituted or unsubstituted alkenyloxyl group having 2 to 30 carbon atoms, a substituted or unsubstituted aryl group having 8 to 30 carbon atoms alkenylaryl group, a substituted or unsubstituted arylalkoxy group having 7 to 30 carbon atoms, a substituted or unsubstituted arylalkenyl group having 8 to 30 carbon atoms and a substituted or unsubstituted alkoxycarbonyl group having 2 to 20 carbon atoms.

4. The charge-transporting complex according to claim 1, wherein the curable organic semiconductor is a hole-transporting compound to which the cross-linking functional group is bonded,
wherein the hole-transporting compound comprises at least one of a triphenyl amine derivative, an aromatic diamine derivative, an arylene diamine-based derivative, a carbazole derivative, a spiro-arylene diamine derivative, a starburst-type amine-based derivative, a triarylamine derivative, a thiophene derivative, and a triarylphosphine derivative.

5. The charge-transporting complex according to claim 4, wherein the curable organic semiconductor comprises at least one of N4,N4'-bis(4-(6-((3-ethyloxetan-3-yl)methoxy)hexyloxy)phenyl)-N4,N4'-bis(4-methoxyphenyl)biphenyl-4,4'-diamine (QUPD), N4,N4'-bis(4-(6-((3-ethyloxetan-3-yl)methoxy)hexyl)phenyl)-N4,N4'-diphenylbiphenyl-4,4'-diamine (OTPD), oxe-DCDPA(N,N-bis(4-(6-((3-ethyloxetane-3-yl)methoxy)hexyloxy)phenyl)-3,5-di(9H-carbazol-9-yl)benzenamine), vinylbenzyl (VB)-TCTA (tris(4-carbazoyl-9-ylphenyl)amine), N,N'-bis(tolyl)-N,N'-bis(vinylphenyl)-1,1'-biphenyl-4,4'-diamine (DV-TPD), tris[(p-trifluorovinyloxy-biphenyl)]amine (TPA-TFVE), MUPD and AUPD.

6. The charge-transporting complex according to claim 1, wherein the curable organic semiconductor is an electron-transporting compound having the cross-linking functional group bonded thereto, and the electron-transporting compound comprises at least one of an oxadiazole derivative, a triazole derivative, a phenanthroline derivative, a benzoxazole derivative, a benzothiazole derivative, a benzimidazole derivative, a triazine derivative, a benzoquinone derivative, a pyridine derivative, an anthraquinone derivative, a polyquinoline derivative, and a polyfluorene derivative.

7. The charge-transporting complex according to claim 6, wherein the curable organic semiconductor comprises at least one of DV-46PymTAZ(4,6-bis[4-(5-{4-[(4-vinylbenzyloxy)methyl]phenyl}-4-(4-tert-butyl-phenyl)-4H-1,2,4-triazol-3-yl)phenyl]-2-methylpyrimidie), SMH-E-10, TV-TmPY(1,3,5-tris(5(4-vinylphenyl)pyridin-3-yl)benzene) and U-BmPyPB.

8. The charge-transporting complex according to claim 1, wherein luminescence intensity and durability of the charge-transporting complex are adjusted depending upon a concentration of the organic silica precursor.

9. The charge-transporting complex according to claim 8, wherein the concentration of the organic silica precursor is 1.40 % by weight to 7.13 % by weight based on the charge-transporting complex.

10. The charge-transporting complex according to claim 1, wherein the organic silica precursor comprises a compound represented by one of Formulas 9 to 19 below: 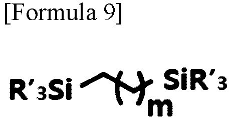 in Formula 9, R' comprises one to three halogen elements or one to three alkoxy (-O-(CH₂)ₓ-CH₃, where X is an integer of 0 to 8.), and m is an integer of 0 to 20, 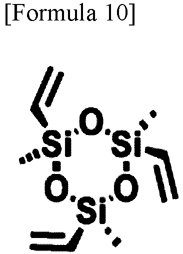 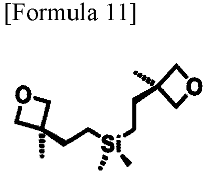 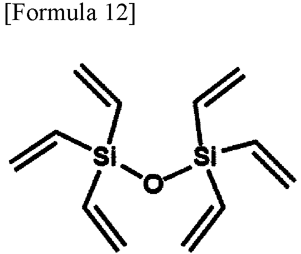 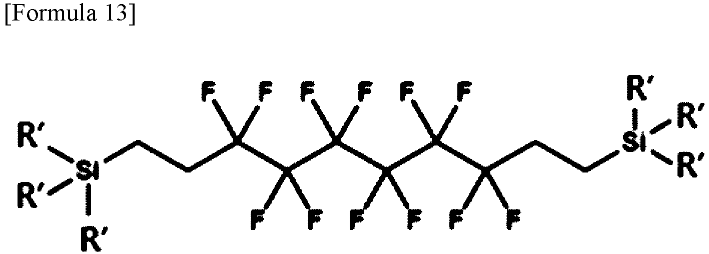 in Formula 13, R' comprises one to three halogen elements or one to three alkoxy (-O-(CH₂)ₓ-CH₃, where X is an integer from 0 to 8,

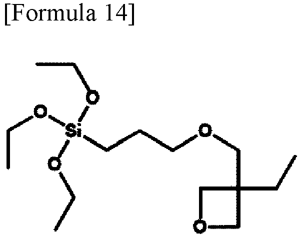

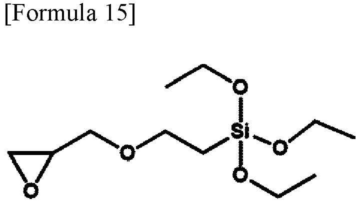

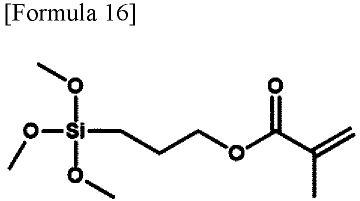

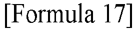

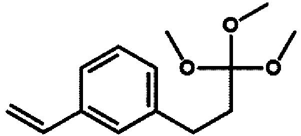

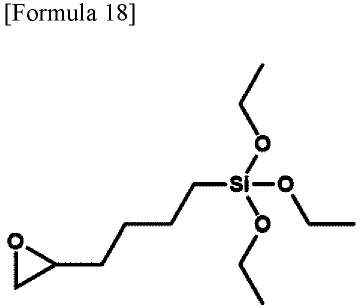

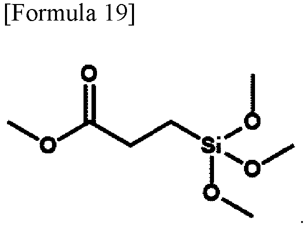

11. The charge-transporting complex according to claim 10, wherein the silicone (-Si-O-Si-) network structure is one of a silicone (-Si-O-Si-)-integrated Single Phase Network (SPN) and a silicone (-Si-O-Si-)-integrated Interpenetrating Polymer Network (IPN).

12. A patterning method for a charge-transporting layer, the patterning method comprising:
forming a charge-transporting layer comprising the charge-transporting complex according to one of claims 1 to 11 on a substrate;
forming a photoresist on the charge-transporting layer;
patterning the photoresist to form a photoresist pattern;
forming a charge-transporting layer pattern by dry-etching the charge-transporting layer using the photoresist pattern as an etching mask; and
removing the photoresist pattern.

13. The patterning method according to claim 12, wherein the charge-transporting complex comprises a silicone (-Si-O-Si-) network structure,
wherein the silicone (-Si-O-Si-) network structure is one of a silicone (-Si-O-Si-)-integrated Single Phase Network (SPN) and a silicone (-Si-O-Si-)-integrated Interpenetrating Polymer Network (IPN).

14. The patterning method according to claim 12, wherein, in the forming of the charge-transporting layer, at least two sub-charge transport layers having different organic silica precursor concentrations are formed on the substrate.

15. The patterning method according to claim 12, wherein, in the forming of the charge-transporting layer pattern, a non-volatile blocking layer is formed on a side surface of the charge-transporting layer pattern due to the silicone (-Si-O-Si-) network structure of the charge-transporting complex.

16. The patterning method according to claim 15, wherein the non-volatile blocking layer comprises at least one of SixOy and SixOyFz where x, y and z are integers from 1 to 4.

17. The patterning method according to claim 12, wherein the charge-transporting layer pattern has a size of 10 nm to 1000 µm.

18. An organic light-emitting device, comprising:
a first electrode formed on a substrate;
an organic light-emitting layer formed on the first electrode;
a second electrode formed on the organic light-emitting layer; and
a charge-transporting layer formed at least one of an interface between the first electrode and the organic light-emitting layer and an interface between the organic light-emitting layer and the second electrode, and configured to comprise the charge-transporting complex according to one of claims 1 to 9.

19. The organic light-emitting device according to claim 18, wherein luminescence intensity and durability of the charge-transporting layer are adjusted depending upon a concentration of the organic silica precursor.

20. The organic light-emitting device according to claim 19, wherein the charge-transporting layer comprises at least two sub-charge transport layers having different organic silica precursor concentrations.

21. The organic light-emitting device according to claim 20, wherein a first sub-charge transport layer and a second sub-charge transport layer are comprised at an interface between the first electrode and organic light-emitting layer of the charge-transporting layer,
wherein a concentration of an organic silica precursor in the second sub-charge transport layer is higher than that of the first sub-charge transport layer.

22. A charge-transporting layer composition, comprising:
a curable organic semiconductor; and
organic silica precursor.

23. The charge-transporting layer composition according to claim 22, wherein the charge-transporting layer composition comprises:
the curable organic semiconductor in an amount of 92.87 % by weight to 98.60 % by weight, and
the organic silica precursor in an amount of 1.40 % by weight to 7.13 % by weight.
